(19) **Europäisches Patentamt**
**European Patent Office**
**Office européen des brevets**

(11) **EP 4 202 969 A1**

(12) **EUROPEAN PATENT APPLICATION**

(43) Date of publication:
**28.06.2023 Bulletin 2023/26**

(21) Application number: **21217583.0**

(22) Date of filing: **23.12.2021**

(51) International Patent Classification (IPC):
**H01J 37/04** (2006.01)      **H01J 37/153** (2006.01)
**H01J 37/26** (2006.01)      **H01J 37/302** (2006.01)

(52) Cooperative Patent Classification (CPC):
**H01J 37/04; H01J 37/153; H01J 37/26;**
**H01J 37/302;** H01J 2237/0453; H01J 2237/0492;
H01J 2237/1205; H01J 2237/2817; H01J 2237/2826

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventor: **WIELAND, Marco, Jan-Jaco**
**5500 AH Veldhoven (NL)**

(74) Representative: **ASML Netherlands B.V.**
**Corporate Intellectual Property**
**P.O. Box 324**
**5500 AH Veldhoven (NL)**

(54) **ELECTRON-OPTICAL DEVICE WITH COMPENSATION FOR VARIATIONS IN A PROPERTY OF SUB-BEAMS**

(57)    Electron-optical devices and associated methods are disclosed. In one arrangement, an electron-optical device projects a multi-beam of sub-beams of charged particles to a sample. A plurality of plates are provided in which are defined respective aperture arrays. The plates comprise an objective lens array configured to project the sub-beams towards the sample. The aperture arrays defined in at least two of the plates each have a geometrical characteristic configured to apply a perturbation to a corresponding target property of the sub-beams. A controller controls potentials applied to the plates having the geometrical characteristics such that the applied perturbations together substantially compensate for a variation in the target property over a range of a parameter of the device.

## Fig. 12

**Description**

<u>FIELD</u>

The embodiments provided herein relate to compensating for variations in properties of sub-beams of an electron-optical device over a range of operating configurations of the device.

<u>BACKGROUND</u>

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, which may be referred to as samples, for example to detect pattern defects. These tools typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection tool may obtain an image representing characteristics of the material structure of the surface of the sample.

Electron-optical devices may be provided with correction features that reduce aberrations. The correction features may be, for example, variations in the shapes, sizes and/or positions of apertures of aperture arrays defined in plates through which the electron beams pass. Such apertures of the aperture arrays may be nominally uniform, having at least similar shape and size and be positioned at grid points of a nominally regular array. The correction features may vary, adjust, or perturb the shape and/or size of the apertures, for example dependent on the locations of the apertures in the aperture array and/or vary, adjust or perturb the positions of the apertures relative to the grid points of the regular array. Such correction features may be considered to be geometrical characteristics of the apertures of the aperture array. Since the correction features adjust the structural form of apertures they may be referred to as hardcoded corrections. Hardcoded corrections can be contrasted with correction features that are implemented by controlling potentials applied to plates defining the aperture arrays. Such hardcoded corrections cannot readily be changed and may not be optimal in all situations. It would be desirable to enable hardcoded corrections to be effective in a wider range of scenarios.

<u>SUMMARY</u>

It is an object of the present disclosure to improve control of charged particle beams.

According to an aspect of the invention, there is provided an electron-optical device configured to project a multi-beam of sub-beams of charged particles to a sample, the device comprising: a plurality of plates in which are defined respective aperture arrays, wherein the plurality of plates comprises an objective lens array configured to project the sub-beams towards the sample and the aperture arrays defined in at least two of the plates each have a geometrical characteristic configured to apply a perturbation to a corresponding target property of the sub-beams; and a controller configured to apply and control potentials applied to the plates having the geometrical characteristics such that the applied perturbations together substantially compensate for a variation in the target property over a range of a parameter of the device.

According to an aspect of the invention, there is provided a method of compensating for variations in a property of sub-beams of charged particles in a multi-beam projected to a sample, the method comprising: using a plurality of plates to project the sub-beams towards the sample, the plates defining respective aperture arrays and including an objective lens array to project the sub-beams towards the sample, wherein aperture arrays defined in at least two of the plates each have a geometrical characteristic configured to apply a perturbation to a corresponding target property of the sub-beams; and controlling potentials applied to the plates having the geometrical characteristics such that the applied perturbations together substantially compensate for a variation in the target property over a range of a parameter of the device.

According to an aspect of the invention, there is provided a method of compensating for variations in a property of sub-beams of charged particles in a multi-beam projected to a sample in an electron-optical device comprising a plurality of plates in which are defined respective aperture arrays, the plurality of plates comprising an objective lens array, wherein aperture arrays defined in at least two of the plates have geometrical characteristics, the method comprising: projecting sub-beams towards a sample by operating on the sub-beams with plates having apertures arrays with the geometrical characteristics, the operating comprising applying perturbations to a target property of the sub-beams with respective plates; and applying potentials to the aperture plates and controlling the potentials such that the respective perturbations together substantially compensate for a variation in the target property over a range of a parameter of the device.

BRIEF DESCRIPTION OF FIGURES

The above and other aspects of the present disclosure will become more apparent from the description of exemplary embodiments, taken in conjunction with the accompanying drawings.

**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1.**
**FIG. 3** is a schematic diagram of an exemplary electron-optical column comprising a condenser lens array.
**FIG. 4** is a graph of landing energy vs. resolution of an exemplary arrangement.
FIG. **5** is an enlarged diagram of an objective lens and a control lens.
**FIG. 6** is a schematic cross-sectional view of a portion of an objective lens array of an exemplary arrangement.
**FIG. 7** is bottom view of the portion of the objective lens array of **FIG. 6.**
**FIG. 8** is a bottom view of a modified version of the portion of the objective lens array of **FIG. 6.**
**FIG. 9** is an enlarged schematic cross-sectional view of a detector incorporated in the objective lens of **FIG. 6.**
**FIG. 10** is a schematic diagram of an exemplary electron-optical device comprising a macro collimator and macro scan deflector.
**FIG. 11** is a top view of a portion of a plate defining an aperture array having apertures with a range of different aperture areas for compensating for off-axis aberrations such as field curvature.
**FIG. 12** is a top view of a portion of a plate defining an aperture array having apertures with a range of different ellipticities for compensating for off-axis aberrations such as astigmatism.
**FIG. 13** is a top view of a portion of a plate defining an aperture array having apertures that are displaced with respect to nominal positions to compensate for off-axis aberrations such as distortion caused by telecentricity error.
**FIG. 14** is a schematic cross-sectional view of portions of a control lens array and an objective lens array of an electron-optical device.
**FIG. 15** is a schematic diagram of an exemplary electron-optical device comprising a beam separator.
**FIG. 16** is a schematic cross-sectional view of portions of electrodes in an objective lens array to illustrate electrode distortion (bow).
**FIG. 17** is a graph of beam current versus resolution showing curves of minimized resolution for two different landing energies.
**FIG. 18** is the graph of **FIG. 17** additionally showing curves in which landing energy is stepped from 2.5keV to IkeV with fixed image plane and at minimized resolution for each of eight different physical configurations of the system.
**FIG. 19** is the graph of **FIG. 18** with a curve of stepped landing energy at fixed image plane position being shown for one of the physical configurations of the electron optical device (i.e. one set of hardcoded corrections) and with additional curves showing variation of beam current achieved by controlling demagnification (by controlling potentials applied to plates of an objective lens array assembly).
**FIG. 20** is a schematic side view of an electron-optical device comprising plates with geometrical characteristics configured to apply perturbations to sub-beam properties and a varying electron-optical device up-beam of the plates.
**FIG. 21** is a graph depicting how a sensitivity (Ast/Elli) of astigmatism (Ast) to changes in aperture ellipticities (Elli) varies for different plates over a range of landing energies (LE).
**FIG. 22** is a graph showing how defocus from astigmatism (Defocus(Ast)) varies as a function of landing energy (LE) for three different combinations of plates used for compensation.
**FIG. 23** is a graph depicting how a sensitivity (Ast/Elli) of astigmatism (Ast) to changes in aperture ellipticities (Elli) varies for different plates over a range of ratios of linear demagnification to angular demagnification (M/Ma).
**FIG. 24** is a graph depicting how a sensitivity (Defocus/diam) of defocus (Defocus) due to field curvature to changes in aperture diameters (diam) varies for different plates over a range of ratios of linear demagnification to angular demagnification (M/Ma).
**FIG. 25** is a graph showing how defocus from astigmatism (Defocus(Ast)) varies as a function of the ratio of linear demagnification to angular demagnification for three different combinations of plates used for compensation.
**FIG. 26** is the graph of **FIG. 25** with the single plate case omitted, thereby comparing performance of compensation using two plates with compensation using three plates.

FIG. 27 is a graph showing how optimal resolution varies as a function of beam current when beam current is varied by varying demagnification for implementations with and without use of multiple plates with geometrical characteristics to compensate for aberrations.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000$^{th}$ of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

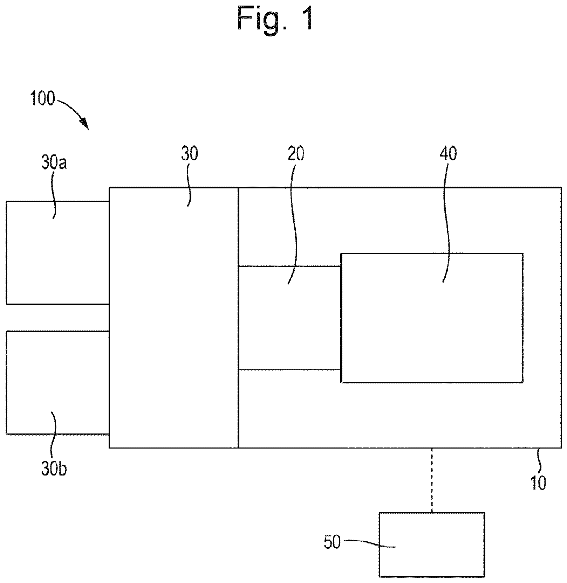

Reference is now made to FIG. 1, which is a schematic diagram illustrating an exemplary charged particle beam inspection apparatus 100, which may also be referred to as a charged particle beam assessment system or simply assessment system. The charged particle beam inspection apparatus 100 of FIG. 1 includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

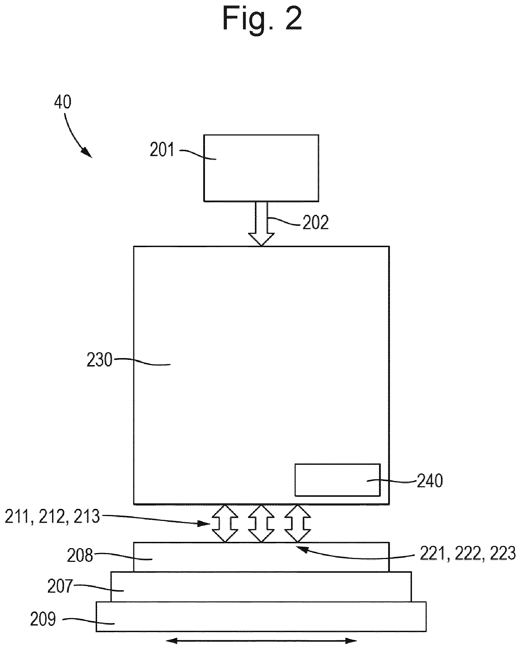

Reference is now made to **FIG. 2,** which is a schematic diagram illustrating an exemplary electron beam tool 40 including a multi-beam inspection tool that is part of the exemplary charged particle beam inspection apparatus 100 of **FIG. 1.** Multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an illumination apparatus. The sample holder 207 is supported by motorized or actuated stage 209 so as to hold a sample 208 (e.g., a substrate or a mask) for inspection. Multi-beam electron beam tool 40 further comprises an electron detection device 240.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202.

Projection apparatus 230 is configured to convert primary electron beam 202 into a plurality of sub-beams 211, 212, 213 and to direct each sub-beam onto the sample 208. Although three sub-beams are illustrated for simplicity, there may be many tens, many hundreds, many thousands, many tens of thousands, or even hundreds of thousands (or more) of sub-beams. The sub-beams may be referred to as beamlets.

Controller 50 may be connected to various parts of charged particle beam inspection apparatus 100 of **FIG. 1,** such as electron source 201, electron detection device 240, projection apparatus 230, and motorized stage 209. Controller 50 may perform various image and signal processing functions. Controller 50 may also generate various control signals to govern operations of the charged particle beam inspection apparatus, including the charged particle multi-beam apparatus.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons are generated from the sample 208 which include secondary electrons and backscattered electrons which may be referred to as signal particles. The secondary electrons typically have electron energy $\leq$ 50 eV and backscattered electrons typically have electron energy between 50 eV and the landing energy of primary sub-beams 211, 212, and 213.

Electron detection device 240 is configured to detect secondary electrons and/or backscattered electrons and to generate corresponding signals which are sent to controller 50 or a signal processing system (not shown), e.g. to construct images of the corresponding scanned areas of sample 208. Electron detection device may be incorporated into the projection apparatus or may be separate therefrom, with a secondary optical column being provided to direct secondary electrons and/or backscattered electrons to the electron detection device.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated in so far as the combined stepping and scanning strategy at least of the stage.

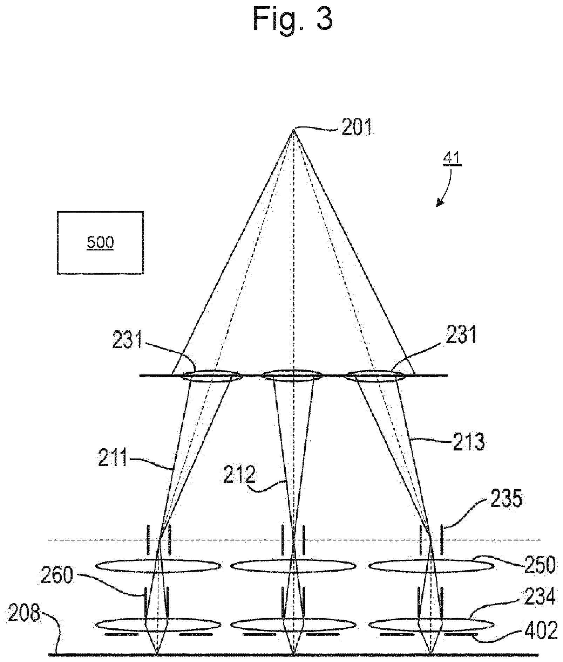

**FIG. 3** is a schematic diagram of an exemplary electron-optical column for use in an assessment system. The electron-optical column is an example of an electron-optical device. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along sub-beam paths of sub-beams of a multi-beam.

Electron source 201 directs electrons toward an array of condenser lenses 231 forming part of projection device 230. The electron source is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for sub-beams through the plates. At least two of the plates are maintained during operation at different potentials to achieve the desired lensing effect. Between the plates of the condenser lens array are electrically insulating plates for example made of an insulating material such as ceramic or glass, with one or more apertures for the sub-beams. In an alternative arrangement, one or more of the plates may feature apertures that each have their own electrode, for example with an array of electrodes around their perimeter or arranged in groups of apertures having a common electrode.

In an arrangement the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. A collimator or an array of collimators may be positioned to operate on the respective intermediate focus 233. The collimators may take the form of deflectors 235 provided at the intermediate focuses 233. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample).

Below (i.e. downbeam or further from source 201) deflectors 235 there is a control lens array 250 comprising a control lens 251 for each sub-beam 211, 212, 213. Control lens array 250 may comprise two or more, preferably at least three, plate electrode arrays connected to respective potential sources, preferably with insulating plates in contact with the electrodes for example between the electrodes. Each of the plate electrode arrays may be referred to as a control electrode. A function of control lens array 250 is to optimize the beam opening angle with respect to the demagnification of the beam and/or to control the beam energy delivered to the objective lenses 234, each of which directs a respective sub-beam 211, 212, 213 onto the sample 208.

Optionally an array of scan deflectors 260 is provided between the control lens array 250 and the array of objective lenses 234 (objective lens array). The array of scan deflectors 260 comprises a scan deflector 261 for each sub-beam 211, 212, 213. Each scan deflector is configured to deflect a respective sub-beam 211, 212, 213 in one or two directions so as to scan the sub beam across the sample 208 in one or two directions.

A detector module 402 of a detector is provided within or between the objective lenses 234 and the sample 208 to detect signal electrons/ particles emitted from the sample 208. An exemplary construction of such a detector module 402 is described below. Note that the detector additionally or alternatively may have detector elements up-beam along the primary beam path of the objective lens array or even the control lens array.

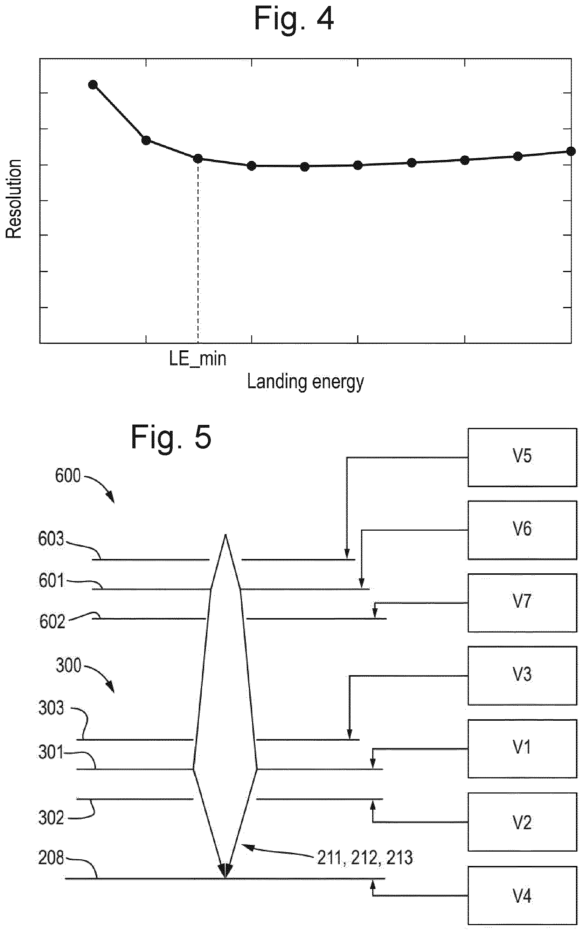

The electron-optical device of **FIG. 3** is configured to control the landing energy of the electrons on the sample by varying the potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. A controller may be configured to control the landing energy to any desired value within a predetermined range or to a desired one of a plurality of predetermined values. In an embodiment, the landing energy can be controlled to a desired value in a predetermined range, e.g. from 1000 eV to 5000 eV. **FIG. 4** is a graph depicting resolution as a function of landing energy, assuming the beam opening angle/demagnification is re-optimized for changing landing energy. As can be seen, the resolution of the assessment tool can be kept substantially constant with change in landing energy down to a minimum value LE_min. Resolution deteriorates below LE_min because it is necessary to reduce the lens strength of, and electric fields within, the objective lens in order to maintain a minimum spacing between objective lens and/or detector and the sample. Exchangeable modules, as discussed further below, may also be employed to vary or control the landing energy.

Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can also be referred to as a refocus lens as it can function to correct the focus position in view of changes in the landing energy. Desirably, each control lens comprises three electrodes so as to provide two independent control variables as further discussed below. For example, one of the electrodes can be used to control demagnification while a different electrode can be used to independently control landing energy. Alternatively each control lens may have only two electrodes. When there are only two electrodes, in contrast, one of the electrodes may need to control both demagnification and landing energy.

**FIG. 5** is an enlarged schematic view of one objective lens 300 of the objective lens array and one control lens 600 of the control lens array 250. Objective lens 300 can be configured to demagnify the electron beam by a factor greater than 10, desirably in the range of 50 to 100 or more. The objective lens comprises a middle or first electrode 301, a lower or second electrode 302 and an upper or third electrode 303. Voltage sources V1, V2, V3 are configured to apply potentials to the first, second and third electrodes respectively. A further voltage source V4 is connected to the sample to apply a fourth potential, which may be ground. Potentials can be defined relative to the sample 208. The first, second and third electrodes are each provided with an aperture through which the respective sub-beam propagates. The second potential can be similar to the potential of the sample, e.g. in the range of from 50 V to 200 V more positive than the sample. Alternatively the second potential can be in the range of from about +500 V to about +1,500 V relative to the sample. A higher potential is useful if the detector module 402 is higher in the optical column than the lowest electrode. The first and/or second potentials can be varied per aperture or group of apertures to effect focus corrections.

Desirably, in an embodiment the third electrode is omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam.

As mentioned above, it is desirable to use the control lens to determine the landing energy. However, it is possible to use in addition the objective lens 300 to control the landing energy. In such a case, the potential difference over the objective lens is changed when a different landing energy is selected. One example of a situation where it is desirable to partly change the landing energy by changing the potential difference over the objective lens is to prevent the focus of the sub-beams getting too close to the objective lens. This situation can, for example, occur if the landing energy is lowered. This is because the focal length of the objective lens roughly scales with the landing energy chosen. By lowering the potential difference over the objective lens, and thereby lowering the electric field inside the objective lens, the focal length of the objective lens is made larger again, resulting in a focus position further below the objective lens.

In the arrangement depicted, control lens 600 comprises three electrodes 601 - 603 connected to potential sources V5 to V7. Electrodes 601 - 603 may be spaced a few millimeters (e.g. 3mm) apart. The spacing between the control lens and the objective lens (i.e. the gap between lower electrode 602 and the upper electrode of the objective lens) can be selected from a wide range, e.g. from 2mm to 200 mm or more. A small separation makes alignment easier whereas a larger separation allows a weaker lens to be used, reducing aberrations. Desirably, the potential V5 of the uppermost electrode 603 of the control lens 600 is maintained the same as the potential of the next electron-optic element up-beam of the control lens (e.g. deflectors 235). The potential V7 applied to the lower electrode 602 can be varied to determine the beam energy. The potential V6 applied to the middle electrode 601 can be varied to determine the lens strength of the control lens 600 and hence control the opening angle and demagnification of the beam. Desirably, the lower electrode 602 of the control lens and the uppermost electrode of the objective lens and the sample has substantially the same potential. In one design the upper electrode of the objective lens V3 is omitted. In this case desirably the lower electrode 602 of the control lens and electrode 301 of the objective lens have substantially the same potential. It should be noted that even if the landing energy does not need to be changed, or is changed by other means, the control lens can be used to control the beam opening angle. The position of the focus of a sub-beam is determined by the combination of the actions of the respective control lens and the respective objective lens.

In an example, to obtain landing energies in the range of 1.5 kV to 2.5 kV, potentials V1, V2, V4, V5, V6 and V7 can be set as indicated in Table 1 below. The potentials in this table are given as values of beam energy in keV, which is equivalent to the electrode potential relative to the cathode of the beam source 201. It will be understood that in designing an electron-optical device there is considerable design freedom as to which point in the electron-optical device is set to a ground potential and the operation of the electron-optical device is determined by potential differences rather than absolute potentials.

Table 1

| Landing Energy | 1.5 keV | 2.5 keV | 3.5 keV |
| --- | --- | --- | --- |
| V1 | 29 keV | 30 keV | 31 keV |
| V2 | 1.55 keV | 2.55 keV | 3.55 keV |
| V3 (or omitted) | 29 keV | 30 keV | 31 keV |
| V4 | 1.5 keV | 2.5 keV | 3.5 keV |
| V5 | 30 keV | 30 keV | 30 keV |
| V6 | 19.3 keV | 20.1 keV | 20.9 keV |
| V7 | 29 keV | 30 keV | 31 keV |

It will be seen that the beam energy at V1, V3 and V7 is the same. In embodiments the beam energy at these points may be between 10 keV and 50 keV. If a lower potential is selected, the electrode spacings may be reduced, especially in the objective lens, to limit reduction of the electric fields.

When the control lens, rather than the condenser lens, is used for opening angle/demagnification correction of the electron beam, the collimator remains at the intermediate focus so there is no need for astigmatism correction of the collimator. In addition, the landing energy can be varied over a wide range of energies whilst maintaining an optimum field strength in the objective lens. This minimizes aberrations of the objective lens. The strength of the condenser lens (if used) is also maintained constant, avoiding any introduction of additional aberrations due to the collimator not being at the intermediate focal plane or to changes in the path of the electron through the condenser lens.

In some embodiments, the charged particle assessment tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses of condenser lens array 231 (e.g. with each such aberration corrector being integrated with, or directly adjacent to, one or more of the condenser lenses 231). This is desirable because at or near the condenser lenses of condenser lens array 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 214 over the sample 208. In an embodiment, the scanning deflectors described in US 2010/0276606, which document is hereby incorporated by reference in its entirety, may be used.

In some embodiments, the objective lens array assembly comprises a detector having a detector module 402 down-beam of at least one electrode of the objective lens array 241. The detector module 402 may take the form of a detector array. In an embodiment, at least a portion of the detector is adjacent to and/or integrated with the objective lens array 241. For example, the detector module 402 may be implemented by integrating a CMOS chip detector into a bottom electrode of the objective lens array 241. Integration of a detector module 402 into the objective lens array replaces a secondary column. The CMOS chip is preferably orientated to face the sample (because of the small distance (e.g., 100μm) between wafer and bottom of the electron-optical system). In an embodiment, electrodes to capture the secondary electron signals are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In order to maximize the detection efficiency, it is desirable to make the electrode surface as large as possible, so that substantially all the area of the objective lens array (excepting the apertures) is occupied by electrodes and each electrode has a diameter substantially equal to the array pitch. In an embodiment the outer shape of the electrode is a circle, but this can be made a square to maximize the detection area. Also, the diameter of the through-substrate hole can be minimized. Typical size of the electron beam is in the order of 5 to 15 micron.

In an embodiment, a single electrode surrounds each aperture. In another embodiment, a plurality of electrode elements are provided around each aperture. The electrons captured by the electrode elements surrounding one aperture may be combined into a single signal or used to generate independent signals. The electrode elements may be divided radially (i.e., to form a plurality of concentric annuluses), angularly (i.e., to form a plurality of sector-like pieces), both radially and angularly or in any other convenient manner.

However, a larger electrode surface leads to a larger parasitic capacitance, so a lower bandwidth. For this reason, it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller. Especially in case a larger electrode gives only a slightly larger detection efficiency, but a significantly larger crosstalk.

The back-scattered and/or secondary electron current collected by electrode is amplified by a Trans Impedance Amplifier.

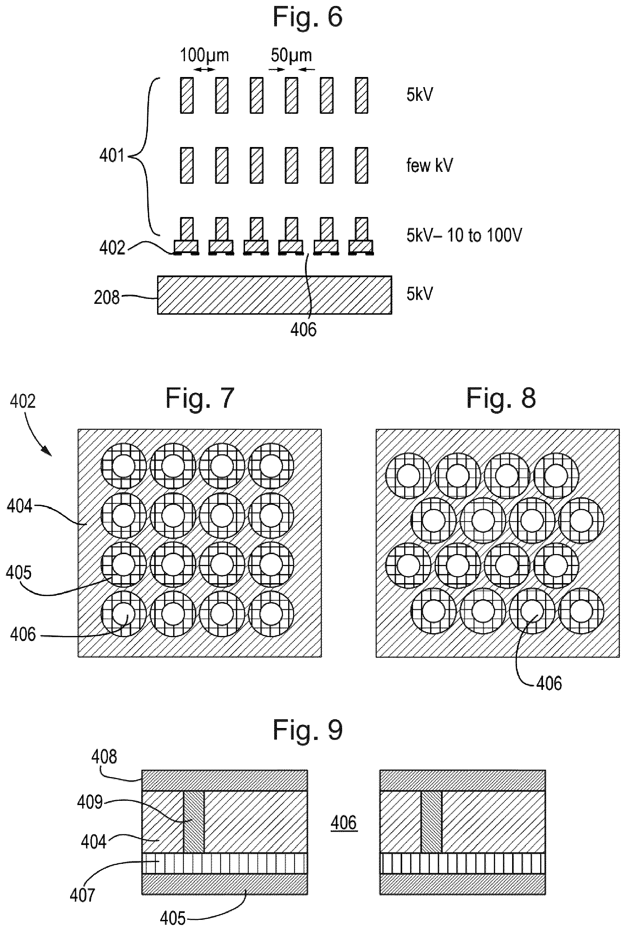

An exemplary embodiment of a detector integrated into an objective lens array is shown in FIG. 6 which illustrates a portion of a multibeam objective lens 401 in schematic cross section. In this embodiment, the detector comprises a detector module 402 comprising a plurality (e.g., an array) of detector elements 405 (e.g., sensor elements such as capture electrodes) preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens 401. **FIG. 7** is a bottom view of detector module 402 which comprises a substrate 404 on which are provided a plurality of capture electrodes 405 each surrounding a beam aperture 406. The beam apertures 406 may be formed by etching through substrate 404. In the arrangement shown in **FIG. 7,** the beam apertures 406 are shown in a rectangular array. The beam apertures 406 can also be differently arranged, e.g. in a hexagonal close packed array as depicted in **FIG. 8.**

**FIG. 9** depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. A circuit featuring these elements may be comprised in a unit area referred to as a cell that is associated with an aperture. The detector module 402 may have several cells each associated with an aperture; preferably the cells have similar shape. Logic layer 407 and capture electrodes 405 can be manufactured using a CMOS process with the capture electrodes 405 forming the final metallization layer.

A wiring layer 408 is provided on the backside of, or within, substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detector module 402 can also be fabricated using bipolar or other manufacturing techniques. A printed circuit board and/or other semiconductor chips may be provided on the backside of detector module 402.

The integrated detector module 402 described above is particularly advantageous when used with a tool having tunable landing energy as secondary electron capture can be optimized for a range of landing energies. A detector module in the form of an array can also be integrated into other electrode arrays, not only the lowest electrode array. Further details and alternative arrangements of a detector module integrated into an objective lens can be found in EP Application Number 20184160.8, which document is hereby incorporated by reference.

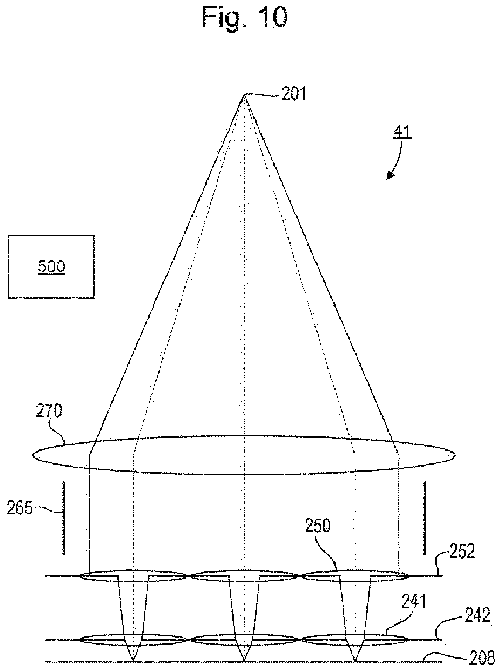

**FIG. 10** is a schematic diagram of a further exemplary electron-optical column for use in an assessment system. This electron-optical column is a further example of an electron-optical device. The column comprises an objective lens array assembly. The objective lens array assembly comprises an objective lens array 241. The objective lens array 241 comprises a plurality of objective lenses. Each objective lens comprises at least two electrodes (e.g., two or three electrodes) connected to respective potential sources. The objective lens array 241 may comprise two or more (e.g., three) plate electrode arrays connected to respective potential sources. The plate electrode arrays of the objective lens array 241 may be referred to as objective electrodes. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208. See also description of objective lenses 234.

In some arrangements, apertures in the objective lens array 241 are adapted to compensate for off-axis aberrations in the multi-beam. For example, the apertures of one or more of the objective electrodes may be shaped, sized and/or positioned to compensation for the off-axis aberrations. The apertures may, for example, have a range of different areas (or a range of diameters) to compensate for field curvature, a range of different ellipticities to compensate for astigmatism, and/or a range of different displacements from nominal grid positions to compensate for distortion caused by telecentricity error. See for example EPA 21166214.3 filed on 31 March 2021 which is hereby incorporated by reference so far as off-axis aberration correction.

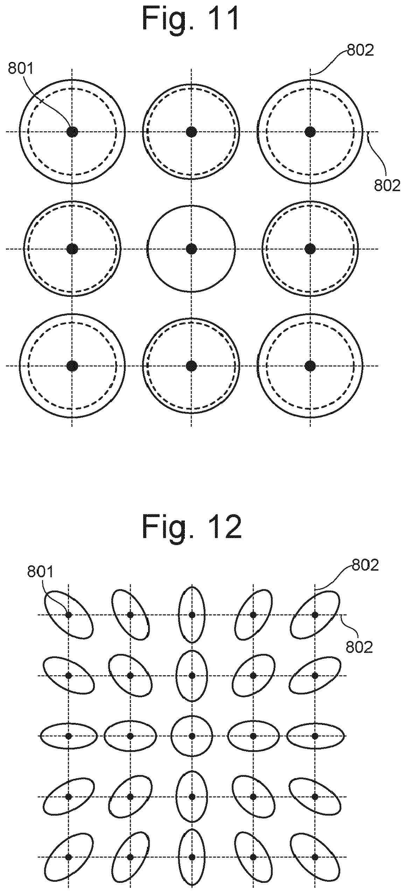

**FIG. 11** depicts an example arrangement of apertures in an aperture array having different areas to compensate for off-axis aberrations such as field curvature. At least a subset of the apertures have a range of different aperture areas. The variations in aperture area depicted in **FIG. 11** are exaggerated for clarity and will in practice be smaller than depicted. The solid line circles represent the apertures having a range of different aperture areas. The broken line circles represent unmodified aperture sizes to assist with visual recognition of the depicted variations in aperture area. The different aperture areas may be described by reference to the diameter of a circle that would have the same aperture area. Thus, aperture areas may be described by reference to a diameter even if the corresponding apertures are not exactly circular. The variations will often involve increases in aperture area as a function of increasing distance from a principal axis of the multi-beam (as depicted schematically in **FIG. 11,** with the principal axis being perpendicular to the page and passing through the centermost aperture). It is also possible for appropriate corrections to involve decreases in aperture area as a function of increasing distance from a principal axis of the multi-beam. In the example shown in **FIG. 11,** the apertures are arranged on a regular grid defined by grid points 801 and grid lines 802.

**FIG. 12** depicts an example arrangement of apertures in an aperture array having a range of ellipticities to compensate for off-axis aberrations such as astigmatism. At least a subset of the apertures have a range of different ellipticities. The variations in ellipticity depicted in **FIG. 12** are exaggerated for clarity and will in practice be smaller than depicted. The range of different ellipticities are selected to compensate for off-axis aberrations such as astigmatism. The variations may involve increases in the size of radially oriented axes, which may be major axes, of apertures as a function of increasing distance from a principal axis of the multi-beam (as depicted schematically in **FIG. 12** with the principal axis being perpendicular to the page and passing through the centermost aperture). It is also possible for appropriate correction to involve increases in the size of azimuthally oriented axes, which may be major axes, of apertures as a function of increasing distance from the principal axis of the multi-beam. In the example shown in **FIG. 12,** the apertures are arranged on a regular grid defined by grid points 801 and grid lines 802.

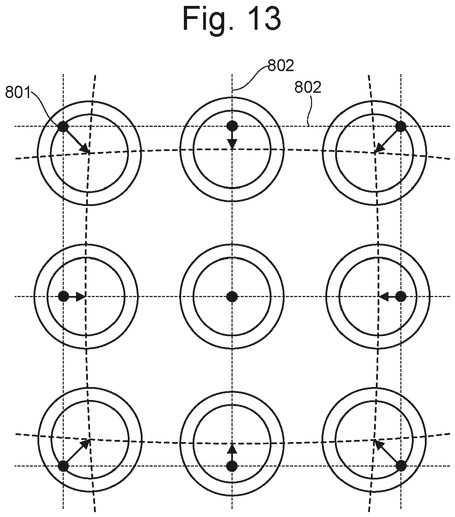

**FIG.** 13 depicts an example arrangement of apertures in an aperture array having a range of different displacements from nominal grid positions to compensate for off-axis aberrations such as distortion caused by telecentricity error. At least a subset of the apertures are displaced relative to nominal positions. Such nominal positions may correspond to the intersection between grid lines 802 of a grid. The apertures are each displaced with respect to a corresponding nominal position 801 on the grid. The nominal positions may be provided on a regular grid. The regular grid may comprise a rectangular, square, or hexagonal grid for example. The nominal positions may represent positions corresponding to an ideal configuration in which there are no off-axis aberrations. The displacements depicted in **FIG. 13** are exaggerated for clarity and will in practice be smaller than depicted. The displacements cause the apertures to lie on a grid (depicted by thick broken lines) that is distorted relative to the nominal grid (depicted by grid lines 802). The off-axis aberrations compensated for by the displacements may comprise distortion caused by telecentricity error. The displacements may be radially inwards as exemplified in **FIG. 13** (towards a principal axis of the multi-beam) or radially outwards. In both cases, the size of the displacements may increase with radial distance. In the simplified example of **FIG. 13** this leads to the corner apertures being displaced more than the side apertures.

The objective lens array assembly further comprises a control lens array 250. The control lens array 250 comprises a plurality of control lenses. Each control lens comprises at least two electrodes (e.g., two or three electrodes) connected to respective potential sources. The control lens array 250 may comprise two or more (e.g., three) plate electrode arrays connected to respective potential sources. The plate electrode arrays of the control lens array 250 may be referred to as control electrodes. The control lens array 250 is associated with the objective lens array 241 (e.g., the two arrays are positioned close to each other and/or mechanically connected to each other and/or controlled together as a unit). The control lens array 250 is positioned up-beam of the objective lens array 241. The control lenses pre-focus the sub-beams (e.g., apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations.

In an embodiment, an electron-optical device comprising the objective lens array assembly is configured to control the objective lens assembly (e.g., by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. In other embodiments, the objective lens array assembly may be configured to form an intermediate focus between the control lens array 250 and the objective lens array 241.

In an embodiment, the control lens array is an exchangeable module, either on its own or in combination with other elements such as the objective lens array and/or detector module. The exchangeable module may be field replaceable, i.e. the module can be swapped for a new module by a field engineer. Field replaceable is intended to mean that the module may be removed and replaced with the same or different module while maintaining the vacuum in which the electron-optical tool 40 is located. Only a section of the column corresponding to the module is vented for the module to be removed and returned or replaced.

The control lens array may be in the same module as an objective lens array 241, i.e. forming an objective lens array assembly or objective lens arrangement, or it may be in a separate module.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. The control lenses may thus be configured to adjust the demagnification and/or beam opening angle of respective sub-beams (e.g. using the electric power source to apply suitable respective potentials to the electrodes of the control lenses and the objective lenses). This optimization can be achieved with having an excessively negative impact on the number of objective lenses and without excessively deteriorating aberrations of the objective lenses (e.g. without increasing the strength of the objective lenses).

The control lens array 250 may be considered as providing electrodes additional to the electrodes of the objective lens array 241 for example. The objective lens array 241 may have any number of additional electrodes associated and proximate to the objective lens array 241, for example five, seven, ten, or fifteen. The additional electrodes such as of the control lens array 250 allow further degrees of freedom for controlling the electron-optical parameters of the sub-beams. Such additional associated electrodes may be considered to be additional electrodes of the objective lens array 241 enabling additional functionality of the respective objective lenses of the objective lens array 241. In an arrangement such electrodes may be considered part of the objective lens array 241 providing additional functionality to the objective lenses of the objective lens array 241. Thus, the control lens is considered to be part of the corresponding objective lens, even to the extent that the control lens is only referred to as being a part of the objective lens.

In the embodiment of **FIG. 10,** the electron-optical device comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In the embodiment of **FIG. 10** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 256 comprises a macroscopic multi-pole deflector, for example with 8 poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). In some arrangements, the scanning of the sub-beams is coordinated with movement of the sample 208. For example, a combination of scanning the sub-beams parallel to the X axis while moving the sample 208 parallel to the Y axis may be repeated at different stepped positions of the sample to process multiple parallel elongate strips on the sample 208. A larger movement of the sample 208 may then be used to leap to a new processing location on the sample 208. An example of this movement is described in EPA 21171877.0filed 3 May 2021 which is hereby incorporated in so far as the control of the beam scanning with stage movement. The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

Any of the objective lens array assemblies described herein may further comprise a detector (e.g. comprising a detector module 402). The detector detects charged particles emitted from the sample 208. The detected charged particles may include any of the charged particles detected by an SEM, including secondary and/or backscattered electrons emitted from the sample 208. An exemplary construction of a detector module 402 is described above with reference to **FIG. 6 to 9.**

In a variation on the embodiment of **FIG. 10** the objective lens array assembly may comprise a scan-deflector array. The scan-deflector array comprises a plurality of scan deflectors. Each scan deflector scans a respective sub-beam over the sample 208. The scan-deflector array may thus comprise a scan deflector for each sub-beam. The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array. The scan-deflector array is positioned between the objective lens array 241 and the control lens array 250. The scan-deflector array may be provided instead of the macro scan deflector 265. In other embodiments both the macro scan deflector 265 and the scan-deflector array are provided and may be operated in synchronization. In some embodiments, as exemplified in **FIG. 10,** the control lens array 250 is the first deflecting or lensing electron-optical array element in the beam path down-beam of the source 201.

A collimator element array may be provided instead of a macro collimator 270. Although not shown, it is also possible to apply this variation to the embodiment of **FIG. 3** to provide an embodiment having a macro scan deflector and a collimator element array. Each collimator element collimates a respective sub-beam. The collimator element array may be more spatially compact than a macro collimator 270. Providing the collimator element array and the scan-deflector array 260 together may therefore provide space saving. This space saving is desirable where a plurality of the electron-optical devices comprising the objective lens array assembly are provided in an electron-optical device array. In such an embodiment there may be no macro condenser lens or a condenser lens array. In this scenario the control lens therefore provides the possibility to optimize the beam opening angle and demagnification for changes in landing energy.

In an embodiment, an electron-optical device in the form of an array is provided. The array may comprise a plurality of any of the electron-optical devices (e.g., electron-optical columns) described herein. Each of the electron-optical devices in the array focuses respective multi-beams simultaneously onto different regions of the same sample. Each electron-optical device in the array may form sub-beams from a beam of charged particles from a different respective source 201. Each respective source 201 may be one source in a plurality of sources 201. At least a subset of the plurality of sources 201 may be provided as a source array. The source array may comprise a plurality of emitters on a common substrate. The focusing of plural multi-beams simultaneously onto different regions of the same sample allows an increased area of the sample 208 to be processed (e.g. assessed) simultaneously. The electron-optical devices in the array may be arranged adjacent to each other so as to project the respective multi-beams onto adjacent regions of the sample 208. Any number of electron-optical devices may be used in the array. Preferably, the number of electron-optical devices is in the range of from 9 to 200. In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array may be configured in any of the ways described herein when referring to a single electron-optical device or system or column. As mentioned above, the scan-deflector array 260 and collimator element array 271 are particularly well suited to incorporation into an electron-optical device in the form of an array because of their spatial compactness, which facilitates positioning of the electron-optical devices in the array close to each other.

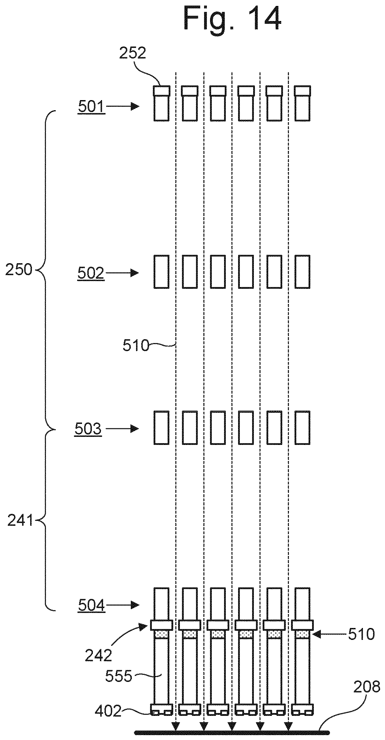

FIG. 14 depicts a portion of a further example of an objective lens array assembly. The lens array assembly comprises a series of electrodes 501 to 504 positioned orthogonal to and/or in series along the sub-beam paths of the multi-beam. Although four electrodes are depicted and described variations may feature as many electrodes as may be desired; thus the lens array assembly may comprise at least four electrodes. This objective lens array assembly could be used in the arrangement of FIG. 10 and is an embodiment of the arrangement of FIG 5. The objective lens array assembly comprises a control lens array 250, 600 and an objective lens array 241, 300. In the arrangement depicted in and described with reference to FIG. 5 the relative potentials of the up beam electrode 303 of the objective lens and the down beam most electrode 602 of the control lens are substantially the same. It should also be noted that the lensing effect of an electrode is provided by a surface of the electrode. As depicted in FIG. 14, the control lens array 250 may be defined by a plurality of electrodes 501 to 503, or at least electrode 501 and the up beam surface of the electrode 503. Each electrode 501, 502, 503 that contributes to the control lens array (and may be referred to as control electrodes even if at least one electrode only partly contributes to the control lens array) may comprise a plate defining an aperture for each sub-beam path 510 (the apertures together being an aperture array). The objective lens array 241 may be defined by a plurality of objective electrodes 503, 504, or at least electrode 504 and the down beam surface of the electrode 503. Each electrode 503, 504 that contributes to the objective lens array (and may be referred to as objective electrodes even if at least one electrode only partly contributes to the objective lens array) may comprise a plate with an aperture for each sub-beam path 510 (the apertures together being an aperture array). The control electrodes 501 to 503 and the objective electrodes 503, 504 may be referred to as lens electrodes. (In a variation the electrode 503 that may be referred to both as an objective electrode and a control electrode may be two separate electrodes spaced apart along the paths of the sub-beams and having substantially the same applied potential).

Five exemplary sub-beam paths 510 are shown in FIG. 14. The control electrodes 501 to 503 are arranged in series along the sub-beam paths 510 and define respective apertures aligned with the sub-beam paths 510 to define the control lenses. Each control lens is thus aligned with a sub-beam path 510 of a respective sub-beam and operates on (e.g. electrostatically manipulates) the sub-beam. Each control electrode 501 to 503 may operate on a portion of the sub-beams or on all of the sub-beams. Each objective lens in the objective lens array 241 may be aligned with a sub-beam path 510 aligned with a respective control lens. The objective lens array 241 directs the sub-beams onto the sample 208.

The arrangement may be described as four or more lens electrodes that are plates. In the plates are defined apertures, for example as aperture arrays, that are aligned with a number of beams in a corresponding beam array. The electrodes may be grouped into two or more electrodes, for example to provide a control electrode group, and an objective electrode group. In an arrangement the objective electrode group has at least three electrodes and the control electrode group has at least two electrodes.

In the example of FIG. 14, the objective electrode 503 furthest from the sample 208 (which may be referred to as the up beam most electrode of the objective lens array 241) and the control electrode 503 closest to the sample 208 (which may be referred to as the down beam most electrode of the control lens array 250) are provided by a common electrode. Thus, the up beam most electrode of the objective electrode group is the common electrode being also a member of the control electrode group. The surface of the common electrode 503 facing away from the sample 208 (which may be described as an up beam surface) contributes functionality to the control lens array and may therefore be considered as comprising part of the control lens array. The surface of the common electrode 503 facing towards the sample 208 (which may be referred to as a down beam surface) contributes functionality to the objective lens array 241 and may therefore be considered as comprising part of the objective lens array 241.

The provision of a common electrode is beneficial where it is desirable for the control lens array 250 to be positioned close to the objective lens array 241. This is more likely to be the case in arrangements where an array of scan deflectors 260 is not used, for example where a macro scan deflector 265 is used instead. This is because where an array of scan deflectors 260 is used it is desirable to position the array of scan deflectors 260 between the control lens array 250 and the objective lens array 241, for example to make a distance between the scanning deflector 260 and the objective lens array 241 as short as possible. An arrangement with a macro scan deflector 265 is exemplified in **FIG. 10.** It is noted, however, that variations on the arrangement of **FIG. 10** are possible that still do not have a condenser lens array but do have an array of scan deflectors. In such arrangements it may also be desirable to position the array of scan deflectors between a control lens array and an objective lens array. Alternatively, the array of scan deflectors could be positioned elsewhere, such as within the control lens array or upbeam of the control lens array, such as between the control lens array and an array of beam-limiting apertures.

In this example of **FIG. 14,** the objective lens array assembly further comprises a beam shaping limiter 242. The beam shaping limiter 242 defines an array of beam-limiting apertures. The beam shaping limiter 242 may be referred to as a beam shaping-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241. In another embodiment it can be an array, for example a bottom most array of the objective lens array 241.

In an arrangement, the beam shaping limiter 242 is structurally integrated with an electrode of the objective lens array 241. Each beam-limiting aperture has a beam limiting effect, allowing only a selected portion of the sub-beam incident onto the beam shaping limiter 242 to pass through the beam-limiting aperture 124. The selected portion may be such that only a portion of the respective sub-beam passing through a central portion of respective apertures in the objective lens array reaches the sample 208.

In some embodiments, the electron-optical device further comprises an upper beam limiter 252. The upper beam limiter 252 defines an array of beam-limiting apertures or generates the array of beams for example from a source beam from source 201. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams down-beam.

The upper beam limiter 252 may form part of the objective lens array assembly. The upper beam limiter 252 may, for example, be adjacent to and/or integrated with the control lens array 250 (e.g. adjacent to and/or integrated with, or even as, an electrode of the control lens array 250 nearest to the source 201). In an embodiment, the upper beam limiter 252 defines beam-limiting apertures that are larger (e.g. have larger cross-sectional area) than beam-limiting apertures of the beam shaping limiter 242. The beam-limiting apertures of the beam shaping limiter 242 may thus be of smaller dimension than the corresponding apertures defined in the objective lens array 241 and/or in the control lens array 250.

The beam shaping limiter 242 is desirably configured to have a beam-limiting effect (i.e. to remove a portion of each sub-beam that is incident on the beam shaping limiter 242). The beam shaping limiter 242 may, for example, be configured to ensure that each sub-beam exiting an objective lens of the objective lens array 241 has passed through the center of the respective objective lens. Further the beam shaping limiter 242 reduces the length over which the scanning operates on the sub-beams. The distance is reduced to the length of the beam path from the beam shaping limiter 242 to the sample surface.

The beam shaping limiter 242 may be formed integrally with a bottom electrode of an objective lens array 241. It is generally desirable to position the beam shaping limiter 242 adjacent to the electrode of each objective lens that has the strongest lensing effect. In an arrangement it is desirable to provide the beam shaping limiter 242 up-beam of a detector module 402 of a detector. Providing the beam shaping limiter 242 up-beam of the detector module 402 ensures that the beam shaping limiter 242 will not obstruct charged particles emitted from the sample 208 and prevent them from reaching the detector module 402. The beam shaping limiter 242 may thus be provided directly adjacent to the detector module 402 in the up-beam direction.

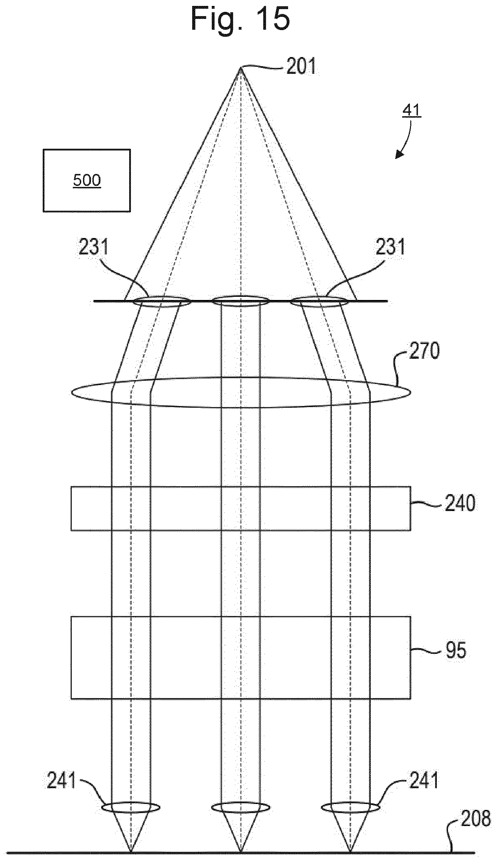

**FIG. 15** schematically depicts a further example of an electron-optical device (electron-optical column). Features that are the same as those described above are given the same reference numerals. For conciseness, such features are not described in detail with reference to **FIG. 15.** For example, the source 201, the condenser lenses 231, the macro collimator 270, the objective lens array 241 and the sample 208 may be as described above. In a variation the macro collimator 270 may comprise a deflector array configured to collimate the sub-beams. Alternatively the collimator may be an array of deflectors configured to collimate the sub-beam. In an arrangement the condenser lens may be a single plate for a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in an embodiment the detector 240 is between the objective lens array 241 and the sample 208. The detector 240 may face the sample 208. Alternatively, as shown in **FIG. 15,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter array so that deflector array may be referred to as a beam separator. The deflector array 95 is configured to provide a magnetic field to disentangle the charged particles projected to the sample 208 relative to the secondary electrons emitted from the sample 208 towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths up beam and down beam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the electron-optical device. In an embodiment photon coupling may be by via a photon transport unit (e.g., an array of optical fibers) to a remote optical detector which generates a detection signal on detection of a photon.

In operation, electron-optical devices generate strong electric fields between electrodes (e.g., plates) of the objective lens array 241. Significant electric fields may also be generated between electrodes elsewhere in the system. Strong electric fields are associated with correspondingly strong electrostatic pressures. Electrostatic pressure is proportional to the field energy density, $\eta_E$, which in turn is proportional to $E^2$ according to $\eta_E = \frac{1}{2} \varepsilon E^2$ (where $\varepsilon$ is the electric permittivity and E is the electric field strength). The electrostatic pressure thus increases quickly with increasing E.

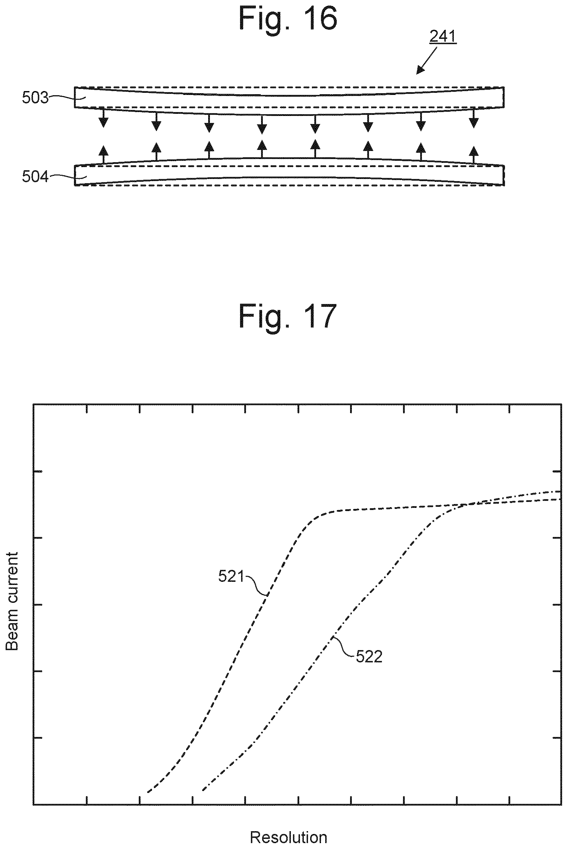

In some arrangements, the electrostatic pressure causes a change in shape and/or position of one or more of the electrodes (plates). Such change in shape and/or position may be referred to as electrode distortion or field-induced distortion of plates. **FIG. 16** depicts such electrode distortion schematically for electrodes 503 and 504 of an objective lens array 241. For ease of depiction, the electrodes 503, 504 are shown without apertures and not to scale. Broken lines, that are shaped as rectangles, depict an example cross-sectional shape of the electrodes 503, 504 before the electron-optical system is turned on (i.e., when no electric field is present between the electrodes 503, 504). In this example, the electrodes 503, 504 are substantially planar at this stage. The solid line rectangles depict example cross-sectional shapes of the electrodes 503, 504 when the electron-optical system is turned on and an example electric field is present between the electrodes. **FIG. 16** depicts a typical case where electrodes bow into a region of high electric field strength. This mode of electrode distortion may be referred to as bow. Bow may cause distortion having a parabolic or approximately parabolic form; that is, the distortion varies as an approximate function of the square of radial position.

Electrode distortion in the objective lens array 241 may affect sub-beams of the multi-beam. The electrode distortion may contribute to field curvature for example. Field curvature is where the focus plane is different for different sub-beams of the multi-beam, which may lead to focus errors at a planar surface of the sample 208. It is possible to configure the objective lens array to compensate for a predicted effect on the sub-beams from a predicted electrode distortion in the objective lens array. The objective lens array may thus be provided with a hardware correction (which may be referred to as a hardcoded correction). In some arrangements, the hardware correction comprises variations in sizes (e.g., diameters where the apertures are circular) of apertures defined in one or more of the electrodes as a function of position in each electrode. Varying the sizes of apertures in the electrodes can compensate for changes in field curvature.

Finite manufacturing tolerances limit the accuracy of electrode distortion prediction. Finite manufacturing tolerances lead to small but significant variations between different manufactured instances of the objective lens array 241, such as differences in electrode thicknesses and/or aperture sizes. These variations can affect the stiffness of the electrodes, which may result in a given electrostatic pressure being associated with different electrode distortions for different manufactured instances. This variability means that hardware corrections of the type described above may not achieve optimal compensation. For typical implementations of the type shown in **FIG. 3,** it is expected that electrode distortion could lead to surface displacements of up to around 10 microns. If a budget defocus amount of 100nm is allocated to this effect, this would imply that electrode distortion should be reproducible to within 1% if a hardware correction (e.g. by varying aperture diameters) is to be effective. It is undesirable to be constrained to such tight manufacturing tolerances. For arrangements of the type shown in **FIG. 10,** the electrode distortion is expected to be much smaller, but it is particularly desirable in such systems to support tunable landing energy. Tuning landing energy leads to significant changes in the electrostatic field in the objective lens array, which may again lead to hardware corrections being inadequate. Arrangements described below aim to improve compensation of an effect of electrode distortion. The improved compensation may allow manufacturing tolerances to be relaxed (e.g. from 1% to 10%) and/or to support tunable landing energy functionality. Arrangements are described below that allow landing energy to be varied while simultaneously suppressing both field curvature and astigmatism.

Arrangements comprising plates defining aperture arrays (e.g., including a control lens array 250 and/or an objective lens array 241) may be configured to perform various functions as described below. These functions may be performed by controlling the plates (e.g. the control lens array 250 and/or the objective lens array 241), for example by controlling potentials applied to the plates. A controller 500 (as depicted schematically in **FIG. 3** and **10**) may be provided for this purpose. As described below, the controller 500 may be computer-implemented, with any suitable combination of elements (e.g. CPUs, RAM, etc.) being used to provide the required functionality. As described above with reference to **FIG. 5**, the control electrodes and objective electrodes may be controlled by connecting the electrodes to potential sources. The controller 500 may thus comprise and/or control the potential sources that apply potentials to the different lens electrodes.

Any reference herein to a device or system being configured to perform functionality is intended to encompass the case where the controller 500 is configured to perform the functionality (e.g., by being suitably programmed to provide the necessary control signals to apparatus such as the potential sources).

In some arrangements, an electron-optical device (e.g. via controller 500) is configured to implement a plurality of selectable landing energies for a sub-beam (optionally for all of the sub-beams) of the multi-beam. The plurality of selectable landing energies may be implemented by applying corresponding potentials to the control electrodes 501 to 503 and the objective electrodes 503 and 504 (e.g. via respective potential sources). Different potentials may be applied for each selectable landing energy. The device thus allows different landing energies to be selected for a sub-beam at different corresponding times. The selectable landing energies may comprise one or more continuous ranges of landing energies. In this case, the device would be able to select any landing energy within the one or more continuous ranges. Alternatively or additionally, the selectable landing energies may comprise a plurality of predetermined discrete landing energies. The selection may be performed by a user. The device may thus receive user input (e.g. via a user interface of a computer system or as an input data stream) and select a selectable landing energy based at least partially (i.e. wholly or partly) on the received user input. Alternatively or additionally, the device may operate at least partially (i.e. wholly or partly) automatically. The device may for example select landing energies based at least partially on a predefined program or in response to one or more input parameters, for example determined by an application or model. The input parameters may represent measurements made by the system for example.

The selection of a landing energy may depend on the particular inspection scenario. For example, the landing energy may be selected to optimize for a parameter of a certain type of signal particle such as secondary electron yield and contrast (which may be defined as the yield difference between a feature and the background). The landing energy that achieves this will be a function of the material being inspected. The nature of the defect of interest may also play a role. Where physical defects are of interest, the material properties will determine secondary electron yield. Where voltage contrast defects are of interest, the charging behavior and therefore secondary electron yield will depend on whether the circuit is able to drain charge. Alternatively or additionally, the landing energy may be selected to control charging (which has an influence on distortion as well as secondary electron yield). Alternatively or additionally, the landing energy may be selected to achieve a desired electron-optical performance. For example, a deterioration of resolution caused by selecting a lower landing energy may be traded off against an improvement in secondary electron yield.

The electron-optical device may be configured (e.g. via controller 500) to select the corresponding potentials for the different landing energies such that a spatial relationship between an image plane of the electron-optical device (for example on the sample) and all of the control electrodes 501 to 503 and objective electrodes 503 and 504 is the same for each of the selectable landing energies. Thus, the separations between all of the electrodes and between each of the electrodes and the image plane of device remains the same regardless of which selectable landing energy is implemented. A user may therefore choose different landing energies without needing to adjust positions of any of the electrodes 501 to 504, the sample 208, or the detector module 402.

In some arrangements, the device is configured (e.g. via controller 500) to apply the same potential to the control electrode 501 furthest from the sample 208 (and part of the control lens that is aligned with the sub-beam path of the sub-beam for which the landing energy is being selected) for at least a portion of the selectable landing energies. The potential applied to the control electrode 501 may, for example, be determined by the beam energy delivered by a source module. The source module provides the charged particle beam from which the sub-beams are derived. The control electrode 501 may for example be fixed at a potential corresponding to a beam energy between 10 keV and 50 keV.

In some arrangements, the device is configured (e.g. via controller 500) to apply a different potential to the objective electrode 503 furthest from the sample 208 (and part of the objective lens that is aligned with the sub-beam path of the sub-beam for which the landing energy is being selected) for each of at least a portion of the selectable landing energies. Each potential may, for example, be selected to provide the same distance between the objective electrode 503 and an image plane of the system. The potential applied to the objective electrode 503 determines the field strength of the electric field in the objective lens array 241 and, therefore, the focal length of each objective lens. It is therefore possible to control the position of the image plane by controlling the potential applied to the objective electrode 503.

In some arrangements, the device is configured (e.g., via controller 500) to control the landing energy (i.e., to select a desired landing energy from a range of available selectable landing energies) by controlling at least a potential applied to the objective electrode 504 closest to the sample (and part of the objective lens that is aligned with the sub-beam path of the sub-beam for which the landing energy is being selected). For example, the objective electrode 504 may be set to a potential corresponding to a beam energy equal to the desired landing energy + a predetermined offset. The predetermined offset may for example be in the range of -50eV to 300eV. The offset is used to set the electric field strength at the sample surface. The electric field strength plays a role in determining secondary electron contrast, especially for voltage contrast use cases. Where secondary electrons are to be detected, the offset voltage may typically be about 50V or higher to ensure adequate detection efficiency, although lower offset voltages may be adequate if the distance between a detector and the sample is sufficiently small. A negative voltage is used if it is desired to repel the secondary electrons, for example if one is interested in the back scatter signal.

In some arrangements, the device is configured (e.g. via controller 500) to control the control lens array 250 to minimize resolution for each of the plurality of selectable landing energies. This may be achieved at least partly by adjusting the control lens array 250 at each selectable landing energy to keep the demagnification of the device (from electron source to sample) divided by the angular demagnification of the device the same for each of the selectable landing energies. This may be achieved, for example, by controlling a potential applied to an intermediate, preferably middle, control electrode 502 of the control lens array 250 (e.g., where the control lens array 250 is defined by three control electrodes 501 to 503; noting the intermediate electrode can only be the middle control electrode of a lens array with an odd-number of electrodes). Controlling the potential applied to an intermediate, preferably the middle, control electrode 502 controls the demagnification. Keeping the demagnification divided by angular demagnification the same for the different landing energies ensures that off-axis aberrations remain constant. Hardcoded corrections for the off-axis aberrations therefore remain valid, thereby keeping net aberrations (after the corrections) low for the different landing energies. This is achieved without needing to exchange respective objective electrodes or the objective lens array 241, which may undesirably introduce down-time and/or inconvenience. It further obviates or reduces the need for having electron components as an exchangeable module that are field replaceable. Thus may reduce the complexity required of the vacuum chamber.

**FIG. 17** is a graph showing predicted variation of beam current of the sub-beams against sub-beam resolution at the sample 208 for an electron-optical system using an electron-optical device without a condenser lens array, for example as depicted in **FIG. 10** featuring a macro-condenser lens 270 or otherwise a macro electron-optical component such as a macro collimator 270 as depicted in **FIG. 15**. Such macro electron-optical components may be magnetic. The curves are obtained by simulating the electrostatic field and ray tracing electrons through the field. Curve 521 corresponds to a landing energy of 2.5keV. Curve 522 corresponds to a landing energy of IkeV. For each curve, each distinct point on the curve represents a distinct physical configuration of the electron-optical column that is optimized for the respective combination of beam current and resolution (including, for example, hard coded off-axis compensations). It is normally desirable for the total current to be high to achieve good throughput and for the resolution to be minimized to provide measurements with good spatial resolution. The graph shows that a balance needs to be achieved between the two quantities: increasing the beam current increases the resolution and vice versa. The curve of beam current against resolution is furthermore different for the different landing energies.

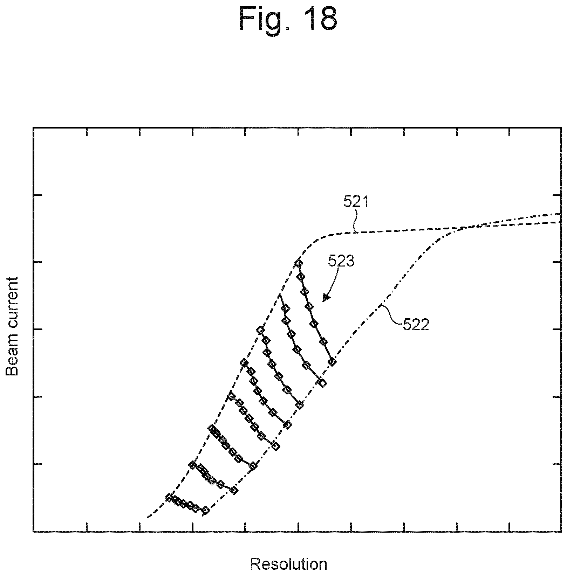

**FIG. 18** is a graph showing eight example curves (solid line curves 523 with open squares) illustrating selection of different landing energies in eight different physical configurations of the electron-optical device. For each configuration, represented by a respective one of the curves 523, plural different landing energies are selected between the landing energy of 2.5keV corresponding to curve 521 and the landing energy of IkeV corresponding to curve 522 in steps of 250eV. At each selected landing energy, the electron-optical system controls the control lens array 250 to minimize resolution by changing the demagnification. This may be achieved, for example, by keeping the demagnification of the electron-optical system divided by angular demagnification of the electron-optical system constant to ensure the hard coded off-axis aberration compensations remain valid and/or by varying the demagnification of the control lens array to compensate for other effects such as changes in field curvature caused by distortion of elements (e.g. electrodes) caused by the electric fields. In each case, potentials applied to the control electrodes and the objective electrodes were also selected to maintain the same spatial relationship between an image plane and all of the control electrodes and objective electrodes. Each curve 523 thus shows a range of different landing energies and corresponding beam currents and minimized resolution that are made available.

In some arrangements, in contrast to the situation exemplified in **FIG. 18,** the resolution is deliberately not minimized. The removal of this restriction allows a range of different beam currents to be selected for each selectable landing beam energy. Thus, instead of being restricted to having the beam current correspond to one of the curves 523 in **FIG. 18,** the beam current can take other values. Higher beam currents may be selected at the expense of larger (less optimal) resolution. By allowing the beam current to be varied in this manner, the electron-optical system thus provides a plurality of selectable beam currents of the sub-beam for each of one or more of the selectable landing beam energies. Thus, in exchange for operating at a larger resolution the beam current may be selected from a range of selectable beam currents at a selected landing beam energy.

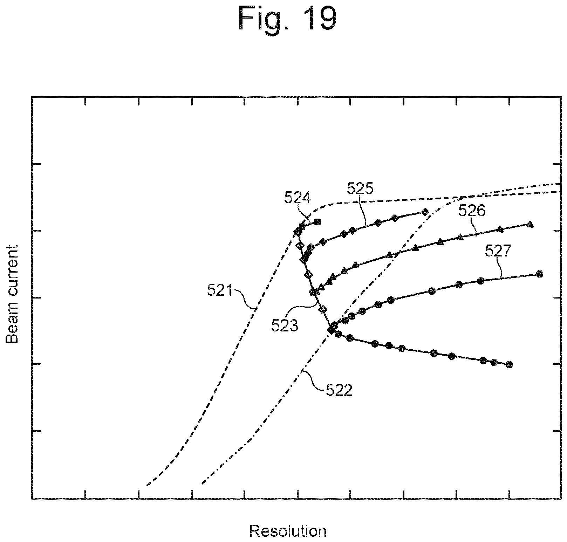

**FIG. 19** is a graph showing four example curves (solid line curves 524 to 527) showing how the beam current can be varied in the manner described above. Each curve 524 to 527 corresponds to a different landing energy (524 = 2.5keV, 525 = 2.0keV, 526 = 1.5keV, 527 = IkeV) but the same physical configuration (same beam limiting aperture diameters and hardcoded off-axis corrections) and the same image plane. Each curve 524 to 527 has a 90 degrees rotated parabolic-like form. In curve 527, both the upper and lower branches of the parabola are shown. In curves 524 to 526, only the upper branch is shown for clarity (i.e. the branch where beam current increases with increasing resolution), although both branches exist. The device may be configured to implement each selectable beam current by selecting a corresponding demagnification of the control lens array 250. Each demagnification corresponds to a different beam current. In the example of FIG. 19, the different points on each of the curves 524 to 527 correspond to different demagnifications. The demagnification may be adjusted for each curve 524 to 527 to optimize resolution. Alternatively, the demagnification may be adjusted to allow resolution to deteriorate while achieving a larger beam current. As described above, in a case where the control lens array 250 comprises three control electrodes 501 to 503, each demagnification may be selected by applying a corresponding potential to the middle electrode 502 of the three control electrodes 501 to 503. Thus, the electron-optical system may be configured to implement each selectable beam current by applying a corresponding potential to the middle electrode 502 of the three control electrodes 501 to 503.

As mentioned in the introductory part of the description, hardcoded corrections in electron-optical devices may not be optimal in all situations. Such hard coded corrections may be applied to a preferred electrode of the objective lens, control lens or other associated electrode or plate. For example, corrections for field curvature and astigmatism may be hardcoded into the diameters and ellipticities of apertures in an aperture array in a plate of an objective lens array (such as a specific plate of the objective lens array). Variations in the field curvature and astigmatism may occur during use of the electron-optical device that cause the hardcoded corrections to become sub-optimal.

In some configurations of electron-optical device, for example, changing the landing energy may cause a change in field curvature. This is because changes in landing energy may need to be accompanied by changes in the electric fields between plates of the objective lens array 241 if the image plane is to be kept in the same place. Electric fields cause distortion of the plates, for example bow, due to electrostatic pressures as discussed above with reference to **FIG. 16.** These distortions contribute to aberrations of the sub-beams such as field curvature.

In some embodiments, a varying electron-optical device provided up beam of the plates also contributes to field curvature. This is the case, for example, in configurations such as those depicted in **FIG. 10** and **15,** where the macro collimator 270 (which may also be referred to as a macroscopic condenser lens) also contributes significantly to field curvature. The magnitude of the field curvature contributed by the macro collimator 270 may be as large as 1-3 microns in the image plane of the objective lens array depending on the demagnification (which may be controlled using the control lens array 250 as described above). Note that the demagnification referred to here is the overall system demagnification determined by the combination of all lenses along the beam path of the electron optical device; the overall system demagnification is of the electron-optical system. Each sub-beam passes through its own set of lenses but the demagnification is approximately the same for all of the sub-beams. The overall system demagnification can thus be quantified by taking an average over the sub-beams or by referring to the demagnification of a reference sub-beam, such as an axially central sub-beam. The field curvature contributed by the macro collimator 270 can be opposite in sign and as large or larger than the variations in field curvature caused by field-induced distortion of plates in the objective lens array 241. A magnitude of the field curvature applied by the macro collimator 270 can thus be controlled to compensate for variations in the field curvature caused by the field-induced distortion of the plates. The magnitude may be controlled, for example, by controlling the demagnification using the control lens array 250. The magnitude is expected to vary in proportion to linear demagnification divided by angular demagnification. However, such varying electron-optical devices (e.g., macro collimator 270) may contribute variations to properties of the sub-beams other than field curvature. For example, in the arrangements of **FIG. 10** and **15** the macro collimator 270 will contribute to astigmatism as well as to field curvature. Calculations of expected field-induced distortions suggest that plates may bow by as much as about 200-400nm over a typical range of landing energies. A magnitude of defocus caused by astigmatism applied by the macro collimator 270 will be about half a magnitude of a field curvature applied by the macro collimator 270. Note that the astigmatism is in terms of focus (for example in a direction from source towards the sample e.g. z-axis relative to the plane of the sample 208) and not in terms of blur or resolution (for example in a direction substantially parallel to the plane of the sample 208 e.g. in a plane of the x and y axes). This implies that astigmatism could vary by between about 100-200nm over a typical landing energy range, which would represent a significant negative contribution to defocus performance.

As landing energy is changed, the demagnification applied by the control lens array 250 can be tuned so that a field curvature applied by the macro collimator 270 continues to cancel a field curvature applied by plates downbeam of the macro collimator 270 (e.g., the objective lens array). However, the change in demagnification will lead to changes in the astigmatism that will not normally be compensated by the downbeam plates. Hardcoded corrections may be present that aim to compensate for astigmatism but these hardcoded corrections cannot change as the demagnification is changed and will therefore normally become invalid as the landing energy is changed. A desirable combination of low field curvature and low astigmatism can be achieved for a narrow range of landing energies but in the absence of the embodiments described herein either or both of field curvature and astigmatism deteriorate relatively quickly outside of the narrow range of landing energies.

Embodiments described below aim to increase the range of situations (e.g., the range of operating parameters of an electron-optical device) for which hardcoded corrections are effective.

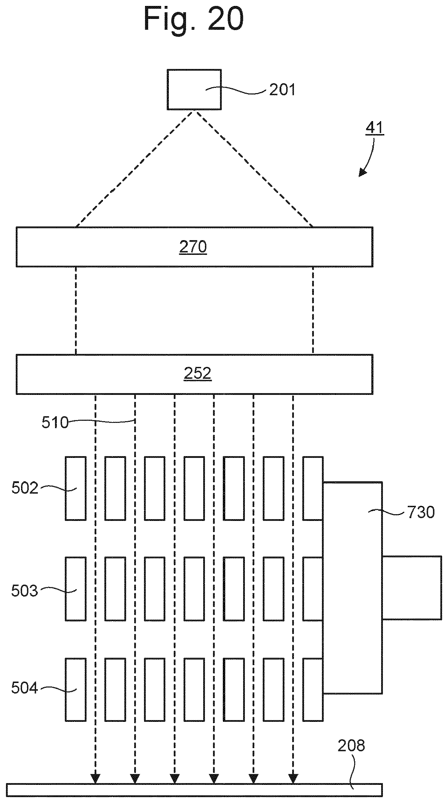

**FIG. 20** schematically depicts a further example of an electron-optical device (electron-optical column). Features that are the same as those described above are given the same reference numerals; for example the arrangements depicted in and described with reference to **FIG. 3**, **10**, **14** and **15**. For conciseness, such features are not described in detail with reference to **FIG. 20.** The features having the same reference numerals take on the same description as earlier stated unless stated to the contrary. For example, the source 201, the macro collimator 270, the upper beam limiter 252, the electrodes 502 to 504 and the sample 208 may be as described above. **FIG. 20** further schematically depicts a rigid mounting 730 for supporting the electrodes 502 to 504. Further details of example arrangements for mounting electrodes may be found in PCT/EP2021/084737 with a priority date of 23 December 2021, which is hereby incorporated in its entirety by reference, in particular in relation to portions of the disclosure relating to mountings for electrodes.

As exemplified with reference to **FIG. 1 to 10, 14,15** and **20,** an electron-optical device may be provided that projects a multi-beam of sub-beams of charged particles to a sample 208.

The device comprises a plurality of plates. The plates may be conductive or have a conductive coating. The plates may therefore define an equipotential surface. The plates may be referred to as electrodes. The plates define respective aperture arrays. Each plate thus defines an aperture array. Each aperture array comprises a plurality of apertures. Each plate may be arranged so that perimeters of the apertures in the array are connected together electrically to be at the same electrical potential as each other (e.g., to form part of the same equipotential surface). The plates may be arranged in series along sub-beam paths 510. Each sub-beam path 510 may intersect a respective aperture in each of the plates. Apertures in different plates may therefore be aligned with each other along respective sub-beam paths 510. In **FIG. 5, 14** and **20,** electrodes 301 to 303, 501 to 504, and 601 to 603 all represent examples of such plates. The electron-optical device applies potentials to the plates to control sub-beams of the multi-beam (e.g., to demagnify the sub-beams and/or focus the sub-beams correctly on a sample 208 to be assessed). Electric fields generated in the vicinity of apertures in such plates are known to create lensing effects for charged particles passing through the apertures.

The plurality of plates comprises an objective lens array 241. A subset or all of the plates may form the objective lens array 241. The objective lens array 241 projects the sub-beams towards the sample 208. The objective lens array 241 may take any of the forms described with reference to **FIG. 3, 5** to **10,** and **14** to **16.** In some arrangements, the plurality of plates further comprises electrodes associated with and proximate to the objective lens array such as a control lens array 250. Where present, the control lens array 250 may take any of the forms described with reference to **FIG. 3,** 5, 10 and **14** and may feature in the electron-optical device 41 depicted in and described with reference to **FIG. 15.** The electron-optical device may be configured to detect signal electrons emitted from the sample 208 (e.g., using a detector, which may comprise a detector module 402 as described above) to obtain information about the sample 208. Such plates may feature in the condenser lens array 231 of **FIG. 3 and 15.**

The electron-optical device may comprise a controller 500 (as depicted schematically in **FIG. 3, 10** and **15**) to control operation of the plates (e.g., to apply and control potentials applied to the plates). As described below, the controller 500 may be computer-implemented, with any suitable combination of elements (e.g., CPUs, RAM, etc.) being used to provide the required functionality. As described above with reference to **FIG. 5**, the plates may be controlled by connecting the plates to potential sources. The controller 500 may thus comprise and/or control potential sources. The potential sources may apply potentials to the different plates, the sample 208, and/or other elements. The controller 500 may further control a stage for supporting the sample 208.

Any reference herein to the electron-optical device (or associated assessment system) being configured to perform functionality is intended to encompass the case where the controller 500 is configured to perform the functionality (e.g. by being suitably programmed to provide the necessary control signals to apparatus such as the potential sources and/or stage).

In an embodiment, the aperture arrays defined in at least two of the plates each have a geometrical characteristic. The geometrical characteristic is configured to apply a perturbation to a corresponding target property of sub-beams passing through the apertures in the plate. The geometrical characteristic thus corresponds to a particular target property of the sub-beams. The target property may comprise astigmatism, field curvature, distortion, coma, or another property of interest. A plate in which are defined apertures having the geometrical characteristics may be referred to as a plate having hardcoded corrections.

In an embodiment, the target property comprises astigmatism and the geometrical characteristic corresponding to the target property (and thus configured to apply corresponding perturbations) comprises a range of different aperture ellipticities in the aperture array, as discussed above with reference to **FIG. 12.**

In an embodiment, the target property comprises field curvature and the geometrical characteristic corresponding to the target property (and thus configured to apply corresponding perturbations) comprises a range of different aperture dimensions, such as areas, in the aperture array, as discussed above with reference to **FIG. 11.**

In an embodiment, the target property comprises distortion (e.g., due to telecentricity error) and the geometrical characteristic corresponding to the target property (and thus configured to apply corresponding perturbations) comprises a range of different aperture positions in the aperture array, relative to respective nominal positions, preferably on a regular grid (e.g., a rectangular or hexagonal grid), as discussed above with reference to **FIG. 13.**

In an embodiment, the target property comprises coma and the geometrical characteristic corresponding to the target property (and thus configured to apply corresponding perturbations) comprises a range of different aperture positions in the aperture array, relative to respective nominal positions, preferably on a regular grid (e.g., a rectangular or hexagonal grid), as discussed above with reference to **FIG. 13.**

Each aperture array may have a single geometrical characteristic that is configured to apply such a perturbation or may have plural different such geometrical characteristics. Each additional geometrical characteristic beyond a first geometrical characteristic may be referred to as a further geometrical characteristic and may take any of the forms described above. Each such further geometrical characteristic is configured to apply a perturbation to a corresponding further target property of the sub-beams and the further target property may comprise any of the target properties described above. An aperture array may thus be configured to apply perturbations to a plurality of target properties by having a corresponding plurality of geometrical characteristics. Any combination of the target properties mentioned above may be perturbed by a single aperture array in this manner.

In some embodiments, the controller 500 is configured to apply and control potentials applied to the plates having the geometrical characteristics such that the applied perturbations together substantially compensate for a variation in the target property corresponding to the geometrical characteristics. The variation in the target property may be an aberration. The compensation of the variation in the target property may suppress the aberration. The device is configured such that the variation is substantially compensated over a range of a parameter of the device. The compensation is not therefore restricted to one particular configuration, which might be the case for typical hardcoded corrections for variations in target properties. The ability to compensate over a wider range of configurations is achieved by providing the geometrical characteristic in multiple different plates, allowing the geometrical characteristic to be applied independently in the different plates, and allowing the plates themselves to be controlled independently. This approach effectively provides at least one additional degree of freedom relative to the case where the geometrical characteristic is provided in a single plate only or is fixed to be the same in each of multiple plates. It has been found that the additional degree of freedom allows the hardcoded corrections to be tuned so as to be applicable over a wider range of operational configurations of the device (e.g., a wider range of parameters of the device).

Providing the geometrical characteristics (which may be referred to as hardcoded corrections) in more than two different plates, for example in three plates, four plates, or five plates, provides further degrees of freedom, thereby allowing a higher degree of compensation to be achieved and/or allowing the compensation to be achieved over longer (or larger) ranges of the parameter and/or over ranges of different parameters. In an arrangement the same geometrical characteristic may be applied to two or more different plates as hardcoded corrections. The geometrical characteristics applied as hardcoded corrections to the array of apertures of the two or more plates may comprise one or more of ellipticity, diameter and displacement from a regular grid. A geometrical characteristic applied to the apertures of a plate may be over a range of the geometrical characteristic so that the magnitude of the geometrical characteristic applied to an aperture in the plate may be different from another aperture in the plate. A particularly good balance of performance to device complexity has been found to be achieved when aperture arrays defined in three of the plates have the geometrical characteristics and the controller applies and control potentials to all three of the plates. It has been found that the applied respective perturbations in such embodiments substantially compensate for the variation in the target property over the range of the parameter of the device to a high level.

The following discussion refers to theoretical models and simulations. In some of these simulations, different data points may represent different hardcoded corrections in one or more plates, but it will be understood that in practice hardcoded corrections cannot typically be changed without mechanically changing and/or replacing one or more elements (e.g., plates) in which the hardcoded corrections are defined.

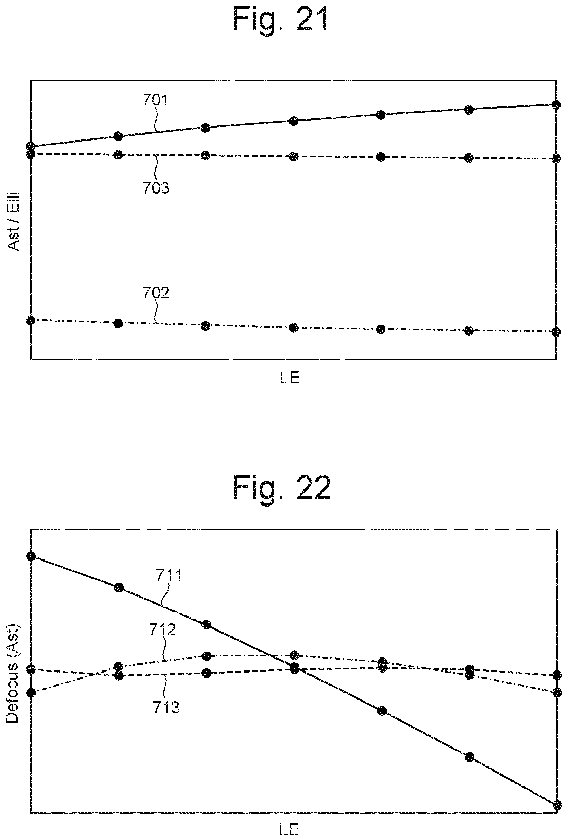

In the use cases discussed above potentials to plates in the objective lens array 241 and control lens 250 in the arrangements of **FIG. 10** and **15** were varied to compensate for field curvature over a range of landing energies. A challenge in this scenario was that the astigmatism also varied as a function of the demagnification used to tune the contribute to field curvature from the macro collimator 270. An aspect of embodiments of the present disclosure was based on the observation that ellipticities in apertures of all plates through which a sub-beam passes (e.g., apertures in plates of a control lens array 250 and objective lens array 241) affect astigmatism and that the sensitivity for each of the plates (i.e., the extent to which a given amount of ellipticity contributes to astigmatism) changes in a different way as a function of landing energy. This is illustrated in the results of simulations shown in **FIG. 21** for an example configuration based on the arrangement of **FIG. 10** and **14.** The simulations were performed at a landing energy of 2.5eV and with resolution tuned to 5nm. Curves 701 to 703 show simulated variations of a sensitivity (referred to as "Ast / Elli") of astigmatism (referred to as "Ast") to ellipticities (referred to as "Elli") in the aperture arrays of respective plates over a range of landing energies, LE. Curve 701 depicts a variation of sensitivity of astigmatism to ellipticities for a plate corresponding to the electrode 502 (which may be referred to as a middle electrode in a control lens array) in **FIG. 14.** Curve 702 depicts a variation of sensitivity of astigmatism to ellipticities for a plate corresponding to the electrode 503 (which may be referred to as a top electrode in an objective lens array) in **FIG. 14.** Curve 703 depicts a variation of sensitivity of astigmatism to ellipticities for a plate corresponding to the electrode 504 (which may be referred to as a bottom electrode in an objective lens array) in **FIG. 14. FIG. 21** shows that, for the different plates, the sensitivities are different at each landing energy and vary differently (e.g., with different slopes) as a function of landing energy.

For a single plate, the variation in sensitivity as a function of landing energy means that even if the contribution to astigmatism from the macro collimator 270 was kept constant (e.g., by keeping the ratio of linear demagnification to angular demagnification constant) the contribution to astigmatism from the plate would vary over the range of landing energies. In practice, however, it will be desirable to adjust the ratio of linear demagnification to angular demagnification to compensate for changes in field curvature, so the astigmatism applied by the macro collimator 270 will vary as a function of landing energy. By appropriate configuration of multiple plates (e.g., by providing each of the multiple plates with a geometrical characteristic that perturbs astigmatism, such as a range of aperture ellipticities as described above with reference to FIG. 12), the multiple plates can be made to apply perturbations to astigmatism that vary as a function of landing energy in a desired way and can therefore be configured to compensate for variations in astigmatism applied by the macro collimator 270. The corrections from different plates may contribute cumulatively or counteract each other (i.e., for some ranges of landing energy an overcompensation may be applied by one plate with a recompensation being applied by another plate). The increased freedom provided by the ability to control the astigmatism correction using multiple plates makes it possible to achieve near perfect correction of both astigmatism and field curvature over a large range of landing energies.

Thus, embodiments of the present disclosure have been found to be effective in the case where the parameter of the device being varied is landing energy and a target property to be compensated includes astigmatism. The respective geometrical characteristics of the aperture arrays allow astigmatism to be made substantially independent of landing energy over the range of landing energies. At the same time, the controller 500 may control potentials applied to the plates such that a perturbation of field curvature applied by the plates substantially compensates a perturbation of field curvature applied by a macro collimator 270 (an example of a varying electron-optical device) up-beam of the plates over the range of landing energies. For example, the controller 500 may control a demagnification applied by the plates such that the perturbation of field curvature applied by the plates substantially compensates the perturbation of field curvature applied by the macro collimator 270. The approach thus allows simultaneous control of field curvature and astigmatism over the range of landing energies.

Field curvature may be considered as the target property to be compensated by the geometrical characteristics in the multiple plates. The respective geometrical characteristics of the aperture arrays, for example such that each aperture array comprises apertures having a range of different aperture areas as described above with reference to **FIG. 11,** also allow field curvature to be made substantially independent of landing energy over the range of landing energies. At the same time, the controller 500 controls demagnification applied by the plates such that the perturbation of astigmatism applied by the plates substantially compensates the perturbation of astigmatism applied by the macro collimator 270 over the range of landing energies.

The improved performance is exemplified in **FIG. 22. FIG. 22** is a graph showing variations in defocus due to astigmatism (referred to as "Defocus (Ast)") as a function of landing energy (LE) over a range of landing energies for three different cases. Each case involves use of the arrangement of **FIG. 14** with a different respective combination of the electrodes 502 to 504 being used to compensate for a variation in astigmatism. In this example, the variation in astigmatism is caused at least partly by an astigmatism applied by a macro collimator 270 up beam of the plates (electrodes), for example as shown in **FIG. 10** and **15**. The geometrical characteristic (e.g., a geometrical characteristic that perturbs astigmatism, such as a range of aperture ellipticities as described above with reference to **FIG. 12**) or geometrical characteristics is/are selected in each case such that a sum of the square of astigmatism over the range of landing energies is minimized. Curve 711 represents a case in which a geometrical characteristic only in an aperture array of the plate corresponding to electrode 504 is used to compensate for the variation in astigmatism caused by the macro collimator 270. Curve 712 represents a case in which geometrical characteristics in aperture arrays in two plates, corresponding respectively to electrodes 502 and 504 in **FIG. 14,** are used to compensate for the variation in astigmatism. Curve 713 represents a case in which geometrical characteristics in aperture arrays in three plates, corresponding respectively to electrodes 502, 503 and 504 in **FIG. 14,** are used to compensate for the variation in astigmatism. As can be seen, compensation of astigmatism over the range of landing energies is much better for the case represented by curve 712 than for the case represented by curve 711. Thus, the additional degree of freedom provided by using geometrical characteristics in apertures arrays of just two plates provides a clear improvement. Curve 713 demonstrates that providing a further degree of freedom provides further improvements to performance.

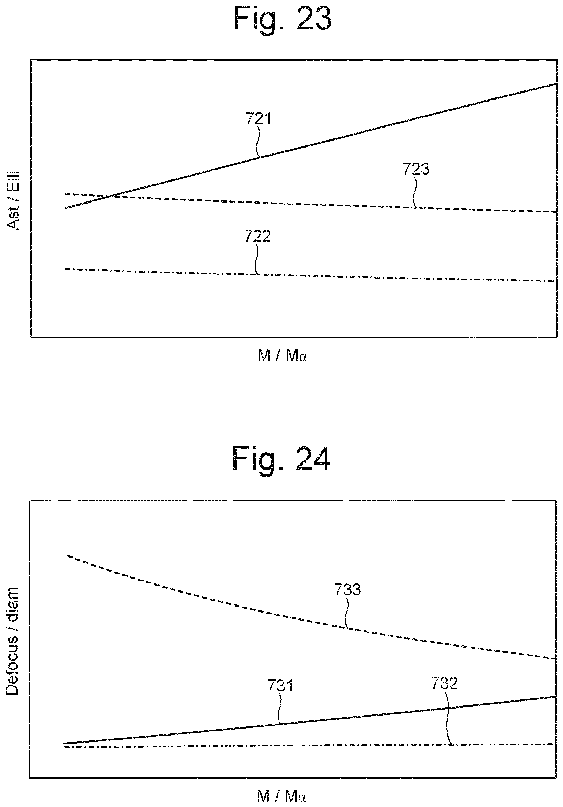

**FIG. 23** to **27** are graphs relating to a further example use case in which geometrical characteristics in multiple plates are tuned to make astigmatism and field curvature substantially independent of the ratio of linear demagnification to angular demagnification, M/Ma.

**FIG. 23** and **24** show the results of simulations to determine variations of sensitivities as a function of M/Ma for plates in an arrangement of the type depicted in **FIG. 10** and **14. FIG. 23** is a graph showing simulated variations of a sensitivity (referred to as "Ast / Elli") of astigmatism (referred to as "Ast") to ellipticities (referred to as "Elli") in the aperture array for three different plates over a range of M/Ma. **FIG. 24** is a graph showing simulated variations of a sensitivity (referred to as "Defocus / diam") of defocus due to field curvature (referred to as "Defocus") to diameters (referred to as "diam") in the aperture array for three different plates over a range of M/Ma. Curves 721 and 731 depict variation of the respective sensitivities for a plate corresponding to the electrode 502 in **FIG. 14** (middle electrode of the control lens array). Curves 722 and 732 depict variations of the respective sensitivities for a plate corresponding to the electrode 503 in **FIG. 14** (top electrode of the objective lens array). Curves 723 and 733 depict variations of the respective sensitivities for a plate corresponding to the electrode 504 in **FIG. 14** (bottom electrode of the objective lens array).

This use case involves changing M/Ma so it is not possible to use this degree of freedom to correct for field curvature. This is why it is necessary to arrange for astigmatism and field curvature to be simultaneously independent of M/Ma, allowing astigmatism and field curvature corrections to remain valid over the range of M/Ma.

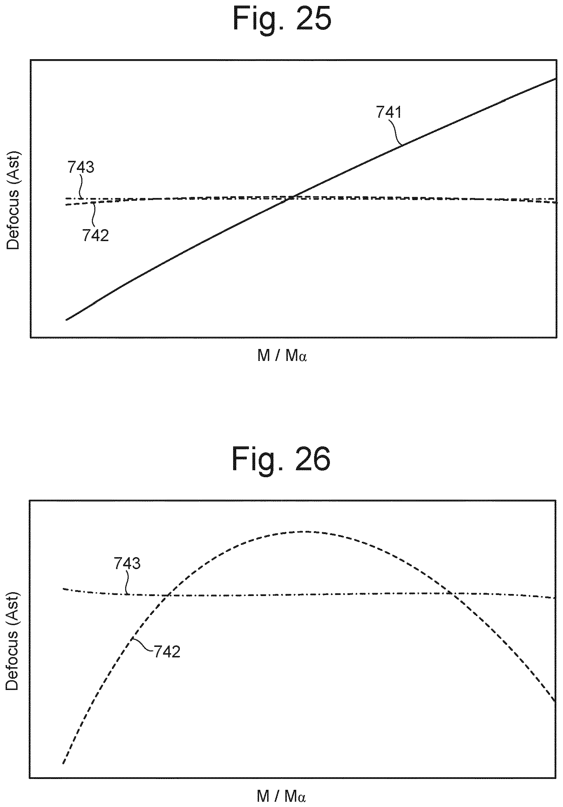

The improved performance achieved by applying the perturbations using the geometrical characteristics in multiple plates is exemplified in **FIG. 25** to **27. FIG. 25** and **26** are graphs showing variations in defocus due to astigmatism (Defocus (Ast)) as a function of M/Ma over a range of M/Ma for three different cases. The defocus in this context is the total defocus (due to astigmatism and field curvature) in the worst case direction. There is a worst case direction because in some directions the defocus due to astigmatism will partly compensate for the defocus due to field curvature and in other directions the defocus due to astigmatism and the defocus due to field curvature will add up. The worst case direction is where the total defocus is largest. **FIG. 25** shows curves 741 to 743 for all three cases, whereas **FIG. 26** only shows curves 742 to 743 for the second and third cases (so that the differences between these two curves can be more clearly seen). Each case involves use of the arrangement of **FIG. 14** with a different respective combinations of the electrodes 502 to 504 being used to compensate for a variation in astigmatism and field curvature. The geometrical characteristics are selected in each case such that a sum of the square of the total defocus (due to astigmatism and field curvature) over the range of M/Ma is minimized. Curve 741 (shown only in **FIG. 25)** represents a case in which geometrical characteristics applied only to apertures of an aperture array in the plate corresponding to electrode 504 are used to compensate for astigmatism and field curvature. Curve 742 represents a case in which geometrical characteristics in aperture arrays in two plates, corresponding respectively to electrodes 502 and 504 in **FIG. 14,** are used to compensate for astigmatism and field curvature. Curve 743 represents a case in which geometrical characteristics in aperture arrays in three plates, corresponding respectively to electrodes 502, 503 and 504 in **FIG. 14,** are used to compensate for astigmatism and field curvature. As can be seen, in a similar way to the situation described above with reference to **FIG. 22,** compensation of astigmatism over the range of M/Ma is better for the case represented by curve 742 than for the case represented by curve 741. Thus, the additional degree of freedom provided by using geometrical characteristics in aperture arrays of just two plates provides an improvement. Curve 743 demonstrates that providing a further degree of freedom provides a significant further improvement to performance. The overall improvement is large in absolute terms because the total defocus variation in the situation represented by curve 741 is simulated to be about 4000nm. In comparison, the defocus variation in the situation represented by curve 711 in **FIG. 22** is simulated to be about 150nm. This is still significant but much smaller.

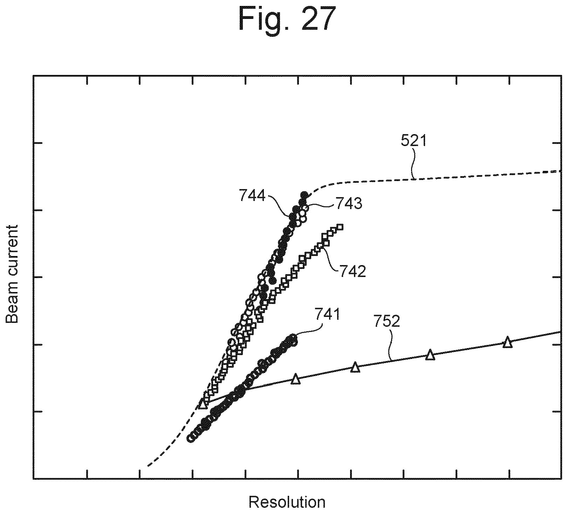

**FIG. 27** demonstrates how the control of astigmatism and field curvature over the range of M/Ma provides improved performance when varying beam current. **FIG. 27** depicts curves of predicted variations of beam current against sub-beam resolution at the sample 208 for a landing energy of 2.5keV and different beam limiting aperture diameters in the upper beam limiter 252. Curves 741 to 744 respectively correspond to beam limiting aperture diameters of 6 micron, 8 micron, 10 micron, and 12 micron, and with fixed hardcoded corrections in the plates corresponding to at least the control electrodes 501, 502, 503 and the objective electrodes, 503, 504, so all of the plates in the arrangement shown and described with reference to at least **FIG. 14** and **20**. Curve 521 shown in **FIG 27** corresponds to curve 521 described above with reference to **FIG. 17** to **19** (with different points on the curve corresponding to different optimized hardcoded corrections). Curve 521 shown in **FIG. 27** therefore shows the fully optimized case where hardcoded corrections are allowed to be reoptimized. The different curves 741 to 744 all represent cases where geometrical characteristics in aperture arrays of multiple plates are used to compensate for astigmatism and field curvature as M/Ma is varied to adjust the beam current, without any re-optimization of hardcoded corrections being allowed. Curve 752 represents an example case where the approach of the present disclosure is not applied, thereby corresponding in form to the different curves 524 to 527 discussed above with reference to **FIG. 19**. Curve 752 represents a case where the beam limiting aperture diameter was 8 micron; the curve 752 is directly comparable to curve 742. In all cases, M/Ma was varied over a range to achieve the observed variation of beam current. At each point, the resolution was optimized using the degrees of freedom available. The increased number of degrees of freedom provided by the embodiments of the present disclosure are seen to allow the curves 741 to 744 to be much steeper than they would otherwise be (as exemplified by curve 752). Indeed, the curves 741 to 744 closely resemble the optimal case 521 where hardcoded corrections are allowed to be reoptimized in the simulation for different values of beam current, but in the case of curves 741 to 744 the performance is achieved without requiring any re-optimization (i.e. change) of the hardcoded corrections. The curves 741 to 744 thus represent performance that can be achieved for fixed hardcoded corrections, i.e., without requiring any exchanges of physical elements such as plates.

Thus, embodiments of the present disclosure have been found to be effective in cases where the parameter of the device (over the range of which the compensation is applied) comprises a beam current of charged particles and the target property comprises one or both of astigmatism and field curvature. In such cases, the respective geometrical characteristics of the aperture arrays are such that astigmatism and field curvature may be made substantially independent of the ratio of total linear demagnification to total angular demagnification over the range of beam current for which the compensation of the target property is applied. The beam current / resolution work point is changed by changing the demagnification. Thus, arranging for the astigmatism and field curvature to be substantially independent of the ratio of total linear demagnification to total angular demagnification means that the beam current / resolution work point (e.g., to follow curve 743 in **FIG. 27**) can be changed with minimal negative impact on performance. It is noted also that in the plots of **FIG. 23** to **26,** the horizontal axes could alternatively have been M rather than M/Ma because there is a 1:1 correspondence between M and M/Ma. It is noted also that for a fixed aperture size there would also be a 1:1 correspondence between linear demagnification and beam current.

The macro collimator 270 (e.g., as depicted in **FIG. 10** and **15**) is an example of a varying electron-optical device that may be provided up beam of the plurality of plates in some embodiments. The varying electron-optical device is configured to apply an electron-optical perturbation to charged particles directed towards the sample. The varying electron-optical device may comprise any macro-electron-optical device. The varying electron-optical device may thus operate on charged particles corresponding to plural sub-beams as a group. In some embodiments, the varying electron-optical device comprises a collimator configured to collimate charged particles corresponding to the sub-beams. The varying electron-optical device may or may not act directly on charged particles in the sub-beams. The varying electron-optical device may act on charged particles before or after the sub-beams are formed. In some embodiments, the varying electron-optical device comprises a condenser lens. In some embodiments, the varying electron-optical device comprises a macro collimator configured to apply a macroscopic collimation to charged particles (before or after they are formed into sub-beams). The perturbation from the varying electron-optical device affects at least the target property of the sub-beams. In some embodiments, the perturbation applied by the varying electron-optical device is the variation in the target property of the sub-beams that is compensated for by the perturbations from the geometrical characteristics in the plurality of plates (e.g. astigmatism and/or field curvature, as discussed above).

In embodiments where such a varying electron-optical device is present, the controller 500 may be configured to control the varying electron-optical device such that the applied electron-optical perturbation and the respective perturbations applied by the aperture arrays together substantially compensate for the variation in the target property over the range of the parameter of the device. The controller 500 may control the varying electron-optical device by applying and controlling one or more potentials applied to the varying electron-optical device (i.e., the varying electron-optical device may comprise an electrostatic element). The controller 500 may control the varying electron-optical device by applying and controlling one or more currents applied to the varying electron-optical device (i.e., the varying electron-optical device may comprise an electro-magnetic element). The varying electron-optical device may thus operate electrostatically and/or magnetically. As demonstrated in FIG. 22, contributions to an aberration such as astigmatism, for example, applied by varying electron-optical device (e.g., macro collimator 270) and by the aperture arrays having the geometrical characteristics may be made to substantially cancel each other out over the range of the parameter (e.g., landing energy) of the electron-optical device.

In some embodiments, the electron-optical device 41 further comprises a beam limiting aperture array. The beam limiting aperture array may be provided up beam of the varying electron-optical device or between the varying electron-optical device and the plates. The beam limiting aperture array may be configured to generate the sub-beams from a source beam. The beam limiting aperture array may be a most up-beam plate which may operates as an electrode. The upper beam limiter 252 described above with reference to **FIG. 14** and **20** is an example of such a beam limiting aperture array. The beam limiting aperture array may take any of the forms described above for the upper beam limiter 252. The source beam comprises the charged particles to which the varying electron-optical device applies the electron-optical perturbation. The electron-optical device may comprise a source 201 for emitting the source beam. The source 201 may take any of the configurations described above with reference to **FIG. 2** and **3.**

The compensation of the target property is achieved over a range of a parameter of the device. The parameter comprises one or more of the following: landing energy of charged particles; beam current of charged particles; separation between the sample and a detector of the electron-optical device; demagnification (e.g. ratio of linear demagnification to angular demagnification); resolution. Examples are discussed above for cases where the parameter is landing energy (see discussion referring to **FIG. 21** and **22**) and demagnification (see discussion referring to **FIG. 23** to **27).**

In some embodiments, the different aperture arrays are configured by the geometrical characteristics to apply perturbations that vary differently as a function of the parameter over the range, at least for perturbations corresponding to the target property. Arranging for the aperture arrays to contribute differently over the range of the parameter facilitates effective compensation of the variation in the target property over the range. **FIG. 21, 23** and **24** demonstrates how this functionality can be achieved by showing how sensitivities of the perturbations to the respective geometrical characteristics may be different for different plates (due to the plate positions) and may vary differently as a function of the parameter of the device.

The perturbations applied by the different plates work together to compensate the variation in the target property. Contributions from different plates may contribute cumulatively or counteract each other, as long as the overall effect is to compensate the variation in the target property. Thus, the controller 500 may control the applied potentials such that perturbations applied by at least two of the aperture arrays counteract each other over at least part of the range of the parameter, at least for perturbations corresponding to the target property. Alternatively or additionally, the controller 500 may control the applied potentials such that perturbations applied by at least two of the aperture arrays contribute cumulatively over at least part of the range of the parameter, at least for perturbations corresponding to the target property.

In some embodiments, the controller is configured to apply and control potentials applied to the plates to maintain a substantially constant spatial relationship between an image plane of the device and a rigid mounting 730 over the range of the parameter of the device. The constant spatial relationship may comprise a constant separation between the image plane and the rigid mounting 730, for example. The mounting 730 holds at least a portion of the plate or plates in a fixed position in a reference frame of the electron-optical device. Other portions of the plate or plates may deform during use due to electric fields generated in regions adjacent to the plates, such as bowing as described herein with reference to **FIG. 16.** Such deformation does not affect the spatial relationship between the image plane and the mounting 730. In some embodiments, the maintaining of the substantially constant spatial relationship between the image plane and the mounting 730 over the range of the parameter of the device is performed while additionally controlling the varying electron-optical device (e.g., macro collimator 270).

Embodiments of the disclosure may be provided as methods, including any of the methods of using the apparatuses described above. The methods include a method of compensating for variations in a property of sub-beams of charged particles in a multi-beam projected to a sample 208. The method may comprise using a plurality of plates to project the sub-beams towards the sample 208. The plates define respective aperture arrays. The plates include an objective lens array to project the sub-beams towards the sample 208. The aperture arrays defined in at least two of the plates each have a geometrical characteristic configured to apply a perturbation to a corresponding target property of the sub-beams. Potentials applied to the plates having the geometrical characteristics may be controlled such that the applied perturbations together substantially compensate for a variation in the target property over a range of a parameter of the device. A method of compensating for variations in a property of sub-beams of charged particles in a multi-beam projected to a sample 208 in an electron-optical device may be provided. The electron-optical device may comprise a plurality of plates in which are defined respective aperture arrays. The plurality of plates comprises an objective lens array. Aperture arrays defined in at least two of the plates have geometrical characteristics. The method comprises projecting sub-beams towards a sample 208 by operating on the sub-beams with plates having apertures arrays with the geometrical characteristics. The operating comprises applying perturbations to a target property of the sub-beams with respective plates. Potentials are applied to the aperture plates and the potentials are controlled such that the respective perturbations together substantially compensate for a variation in the target property over a range of a parameter of the device.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

Where electrodes or other elements are provided that can be set to different potentials relative to each other it will be understood that such electrodes/elements will be electrically isolated from each other. If the electrodes/elements are mechanically connected to each other, electrically insulating connectors may be provided. For example, where electrodes/elements are provided as a series of conductive plates that each define an aperture array, for example to form an objective lens array or control lens array, electrically insulating plates may be provided between the conductive plates. The insulating plates may be connected to the conductive plates and thereby act as insulating connectors. The conductive plates may be separated from each other along sub-beam paths by the insulating plates. In an insulating plate there may be defined an aperture around the path of the multi-beam of sub-beams (e.g. around all the sub-beams).

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. For example, the assessment tool could be any of the charged particle-optical device, e.g. as part of charged particle beam apparatus 100, or more specifically the charged particle-optical device 40 (which may be a charged particle-optical column), and/or as part of an optical lens array assembly, when used for assessment. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle -optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array 250 and objective lens array 241, under the control of the controller or control system or control unit. An actuatable component, such as a stage, may be controllable to actuate and thus move relative to another components such as the beam path using one or more controllers, control systems, or control units to control the actuation of the component.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

References to elements being aligned along a beam path or sub-beam path are understood to mean that the respective elements are positioned along the beam path or sub-beam path.

Reference to a component or system of components or elements being controllable to manipulate or operate on a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 234, the condenser lens 231, correctors, and scan deflector array 260, under the control of the controller or control system or control unit. An actuatable component, such as a stage, may be controllable to actuate and thus move relative to another components such as the beam path using one or more controllers, control systems, or control units to control the actuation of the component.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260) to operate on the charged particle beam in the charged particle beam path. Additionally or alternatively, in an embodiment the controller 50 controls at least one charged particle-optical element (e.g. the detector 240) to operate on the charged particle beam emitted from the sample 208 in response to the charged particle beam. While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

Embodiments of the invention are provided the following clauses:

Clause 1. An electron-optical device configured to project a multi-beam of sub-beams of charged particles to a sample, the device comprising: a plurality of plates in which are defined respective aperture arrays, wherein the plurality of plates comprises an objective lens array configured to project the sub-beams towards the sample and the aperture arrays defined in at least two of the plates each have a geometrical characteristic configured to apply a perturbation to a corresponding target property of the sub-beams; and a controller configured to apply and control potentials applied to the plates having the geometrical characteristics such that the applied perturbations together substantially compensate for a variation in the target property over a range of a parameter of the device.

Clause 2. The device of clause 1, wherein the aperture arrays defined in the at least two of the plates each have one or more further geometrical characteristics, each further geometrical characteristic being configured to apply a perturbation to a corresponding further target property of the sub-beams.

Clause 3. The device of clause 1 or 2, wherein different aperture arrays are configured by the geometrical characteristics to apply perturbations that vary differently as a function of the parameter over the range, at least for perturbations corresponding to the target property.

Clause 4. The device of any preceding clause, wherein the controller is configured to control the applied potentials such that perturbations applied by at least two of the aperture arrays counteract each other over at least part of the range of the parameter, at least for perturbations corresponding to the target property.

Clause 5. The device of any preceding clause, wherein the controller is configured to control the applied potentials such that perturbations applied by at least two of the aperture arrays contribute cumulatively over at least part of the range of the parameter, at least for perturbations corresponding to the target property.

Clause 6. The device of any preceding clause, wherein the aperture arrays defined in three of the plates have the geometrical characteristics and the controller is configured to apply and control potentials applied to all three of the plates such that the applied respective perturbations together substantially compensate for the variation in the target property over the range of the parameter of the device.

Clause 7. The device of any preceding clause, further comprising a varying electron-optical device up beam of the plurality of plates, the varying electron-optical device configured to apply an electron-optical perturbation to charged particles directed towards the sample, the perturbation being such as to affect at least the target property of the sub-beams.

Clause 8. The device of clause 7, wherein the controller is configured to control the varying electron-optical device such that the applied electron-optical perturbation and the respective perturbations applied by the aperture arrays together substantially compensate for the variation in the target property over the range of the parameter of the device.

Clause 9. The device of clause 7 or 8, wherein the applied electron-optical perturbation forms at least part of the variation in the target property to be compensated.

Clause 10. The device of any of clauses 7-9, the device comprising a beam limiting aperture array either: up beam of the varying electron-optical device, wherein the beam limiting aperture array is configured to generate the sub-beams; or between the varying electron-optical device and the plates, the beam limiting aperture array being configured to generate the sub-beams from a source beam.

Clause 11. The device of any of clauses 7-10, wherein a source beam comprises the charged particles to which the varying electron-optical device applies the electron-optical perturbation, the device preferably comprising a source for emitting the source beam.

Clause 12. The device of any of clauses 7-11, wherein the varying electron-optical device is a macro-electron-optical device and/or is configured to operate on charged particles corresponding to plural sub-beams as a group.

Clause 13. The device of any of clauses 7-12, wherein the varying electron-optical device is a collimator configured to collimate charged particles corresponding to the sub-beams, preferably acting on the charged particles in the sub-beams, and/or is a condenser lens.

Clause 14. The device of clause 13, wherein the collimator comprises a macro collimator configured to apply a macroscopic collimation.

Clause 15. The device of any preceding clause, wherein the parameter comprises one or more of the following: landing energy of charged particles; beam current of charged particles; separation between the sample and a detector of the electron-optical device; magnification; resolution.

Clause 16. The device of any preceding clause, wherein the target property comprises one or more of the following: astigmatism; field curvature; distortion; coma.

Clause 17. The device of any preceding clause, wherein the target property comprises astigmatism and/or the geometrical characteristic configured to apply the corresponding perturbations comprises a range of different aperture ellipticities in the aperture array.

Clause 18. The device of any preceding clause, wherein the target property comprises field curvature and/or the geometrical characteristic configured to apply the corresponding perturbations comprises a range of different aperture dimensions, such as areas, in the aperture array.

Clause 19. The device of any preceding clause, wherein the target property comprises distortion and/or the geometrical characteristic configured to apply the corresponding perturbations comprises a range of different aperture positions in the aperture array, relative to respective nominal positions, preferably on a regular grid.

Clause 20. The device of any preceding clause, wherein the target property comprises coma and/or the geometrical characteristic configured to apply the corresponding perturbations comprises a range of different aperture positions in the aperture array, relative to respective nominal positions, preferably on a regular grid.

Clause 21. The device of any preceding clause, wherein the controller is configured to apply and control potentials applied to the plates to maintain a substantially constant spatial relationship between an image plane of the device and a rigid mounting supporting at least one of the plates over the range of the parameter of the device, and preferably the controller configured to maintain the substantially constant spatial relationship while additionally controlling the varying electron-optical device over the range of the parameter of the device.

Clause 22. The device of any preceding clause, wherein the parameter comprises landing energy of charged particles and the target property comprises astigmatism.

Clause 23. The device of clause 22, wherein the controller is configured to control potentials applied to the plates such that a perturbation of field curvature applied by the plates substantially compensates a perturbation of field curvature applied by a varying electron-optical device up-beam of the plates over the range of the parameter.

Clause 24. The device of clause 23, wherein the controller is configured to control a demagnification applied by the plates such that the perturbation of field curvature applied by the plates substantially compensates the perturbation of field curvature applied by the varying electron-optical device up-beam of the plates over the range of the parameter.

Clause 25. The device of any preceding clause, wherein the parameter comprises landing energy of charged particles and the target property comprises field curvature.

Clause 26. The device of clause 25, wherein the controller is configured to control a demagnification applied by the plates such that a perturbation of astigmatism applied by the plates substantially compensates a perturbation of astigmatism applied by the varying electron-optical device up-beam of the plates over the range of the parameter.

Clause 27. The device of clause 23, 24, or 26, wherein the varying electron-optical device comprises a macro collimator configured to apply a macroscopic collimation.

Clause 28. The device of any of clauses 22-27, wherein the respective geometrical characteristics of the aperture arrays are such that astigmatism and/or field curvature is/are substantially independent of landing energy over the range of landing energies.

Clause 29. The device of any preceding clause, wherein the parameter comprises beam current of charged particles and the target property comprises one or both of astigmatism and field curvature.

Clause 30. The device of clause 29, wherein the respective geometrical characteristics of the aperture arrays are such that astigmatism and field curvature are substantially independent of the ratio of total linear demagnification to total angular demagnification over the range of beam current.

Clause 31. The device of clause 29 or 30, wherein the controller is configured to control potentials applied to the plates such that a perturbation of field curvature and/or astigmatism applied by the plates substantially compensates a perturbation of field curvature and/or astigmatism applied by a varying electron-optical device up-beam of the plates over the range of the parameter.

Clause 32. The device of any preceding clause, wherein the variation in the target property is an aberration.

Clause 33. A method of compensating for variations in a property of sub-beams of charged particles in a multi-beam projected to a sample, the method comprising: using a plurality of plates to project the sub-beams towards the sample, the plates defining respective aperture arrays and including an objective lens array to project the sub-beams towards the sample, wherein aperture arrays defined in at least two of the plates each have a geometrical characteristic configured to apply a perturbation to a corresponding target property of the sub-beams; and controlling potentials applied to the plates having the geometrical characteristics such that the applied perturbations together substantially compensate for a variation in the target property over a range of a parameter of the device.

Clause 34. A method of compensating for variations in a property of sub-beams of charged particles in a multi-beam projected to a sample in an electron-optical device comprising a plurality of plates in which are defined respective aperture arrays, the plurality of plates comprising an objective lens array, wherein aperture arrays defined in at least two of the plates have geometrical characteristics, the method comprising: projecting sub-beams towards a sample by operating on the sub-beams with plates having apertures arrays with the geometrical characteristics, the operating comprising applying perturbations to a target property of the sub-beams with respective plates; and applying potentials to the aperture plates and controlling the potentials such that the respective perturbations together substantially compensate for a variation in the target property over a range of a parameter of the device.

**Claims**

1. An electron-optical device configured to project a multi-beam of sub-beams of charged particles to a sample, the device comprising:

   a plurality of plates in which are defined respective aperture arrays, wherein the plurality of plates comprises an objective lens array configured to project the sub-beams towards the sample and the aperture arrays defined in at least two of the plates each have a geometrical characteristic configured to apply a perturbation to a corresponding target property of the sub-beams; and
   a controller configured to apply and control potentials applied to the plates having the geometrical characteristics such that the applied perturbations together substantially compensate for a variation in the target property over a range of a parameter of the device.

2. The device of claim 1, wherein the aperture arrays defined in the at least two of the plates each have one or more further geometrical characteristics, each further geometrical characteristic being configured to apply a perturbation to a corresponding further target property of the sub-beams.

3. The device of claim 1 or 2, wherein different aperture arrays are configured by the geometrical characteristics to apply perturbations that vary differently as a function of the parameter over the range, at least for perturbations corresponding to the target property.

4. The device of any preceding claim, wherein the controller is configured to control the applied potentials such that perturbations applied by at least two of the aperture arrays counteract each other over at least part of the range of the parameter, at least for perturbations corresponding to the target property.

5. The device of any preceding claim, wherein the controller is configured to control the applied potentials such that perturbations applied by at least two of the aperture arrays contribute cumulatively over at least part of the range of the parameter, at least for perturbations corresponding to the target property.

6. The device of any preceding claim, wherein the aperture arrays defined in three of the plates have the geometrical characteristics and the controller is configured to apply and control potentials applied to all three of the plates such that the applied respective perturbations together substantially compensate for the variation in the target property over the range of the parameter of the device.

7. The device of any preceding claim, further comprising a varying electron-optical device up beam of the plurality of plates, the varying electron-optical device configured to apply an electron-optical perturbation to charged particles directed towards the sample, the perturbation being such as to affect at least the target property of the sub-beams.

8. The device of claim 7, wherein the controller is configured to control the varying electron-optical device such that the applied electron-optical perturbation and the respective perturbations applied by the aperture arrays together substantially compensate for the variation in the target property over the range of the parameter of the device.

9. The device of claim 7 or 8, wherein the applied electron-optical perturbation forms at least part of the variation in the target property to be compensated.

10. The device of any of claims 7-9, the device comprising a beam limiting aperture array up beam of the varying electron-optical device, wherein the beam limiting aperture array is configured to generate the sub-beams.

11. The device of any of claims 7-10, wherein the varying electron-optical device is a macro-electron-optical device and/or is configured to operate on charged particles corresponding to plural sub-beams as a group.

12. The device of any of claims 7-11, wherein the varying electron-optical device is a collimator configured to collimate charged particles corresponding to the sub-beams, preferably acting on the charged particles in the sub-beams, and/or is a condenser lens.

13. The device of claim 12, wherein the collimator comprises a macro collimator configured to apply a macroscopic collimation.

14. The device of any preceding claim, wherein the parameter comprises one or more of the following: landing energy of charged particles; beam current of charged particles; separation between the sample and a detector of the electron-optical device; magnification; resolution.

15. The device of any preceding claim, wherein the target property comprises one or more of the following: astigmatism; field curvature; distortion; coma.

# Fig. 1

# Fig. 2

Fig. 3

# Fig. 4

# Fig. 5

## Fig. 6

100μm    50μm

5kV

401

few kV

402

5kV– 10 to 100V

208

5kV

406

## Fig. 7

402

404

405

406

## Fig. 8

406

## Fig. 9

408

409

404

407

405

406

# Fig. 10

## Fig. 11

## Fig. 12

# Fig. 13

# Fig. 14

# Fig. 15

# Fig. 16

241

503

504

# Fig. 17

Beam current

521

522

Resolution

# Fig. 18

# Fig. 19

# Fig. 20

## Fig. 21

## Fig. 22

# Fig. 23

# Fig. 24

## Fig. 25

## Fig. 26

# Fig. 27

Europäisches
Patentamt

European
Patent Office

Office européen
des brevets

# EUROPEAN SEARCH REPORT

Application Number

EP 21 21 7583

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/212229 A1 (WIELAND MARCO JAN JACO [NL] ET AL) 27 August 2009 (2009-08-27) * abstract * * paragraphs [0007] - [0011], [0020] - [0060]; claims 1-6; figures 1-4 * ----- | 1-14 | INV. H01J37/04 H01J37/153 H01J37/26 H01J37/302 |
| A | US 2004/232349 A1 (KRUIT PIETER [NL]) 25 November 2004 (2004-11-25) * abstract * * paragraphs [0064] - [0075]; figures 4-10B * ----- | 1-14 | |

TECHNICAL FIELDS
SEARCHED      (IPC)

H01J

The present search report has been drawn up for all claims

| Place of search | Date of completion of the search | Examiner |
|---|---|---|
| Munich | 27 May 2022 | Lang, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...........................................................................................
& : member of the same patent family, corresponding
    document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-13(completely); 14(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

The Search Division considers that the present European patent application does not comply with the requirements of unity of invention and relates to several inventions or groups of inventions, namely:

**1. claims: 1-13(completely); 14(partially)**

An electron-optical device configured to project a multi-beam of sub-beams of charged particles to a sample, the device comprising a plurality of plates in which are defined respective aperture arrays, wherein the plurality of plates comprises an objective lens array configured to project the sub-beams towards the sample and the aperture arrays defined in at least two of the plates each have a geometrical characteristic configured to apply a perturbation to a corresponding target property of the sub-beams; and a controller configured to apply and control potentials applied to the plates having the geometrical characteristics such that the applied perturbations together substantially compensate for a variation in the target property over a range of a parameter of the device (claim 1), wherein the parameter comprises landing energy of charged particles (claim 14, first alternative).
---

**2. claim: 14(partially)**

The device of claim 1, wherein the parameter comprises beam current of charged particles (claim 14, second alternative).
---

**3. claim: 14(partially)**

The device of claim 1, wherein the parameter comprises separation between the sample and a detector of the electron-optical device (claim 14, third alternative).
---

**4. claim: 14(partially)**

The device of claim 1, wherein the parameter comprises magnification (claim 14, fourth alternative).
---

**5. claim: 14(partially)**

The device of claim 1, wherein the parameter comprises resolution (claim 14, fifth alternative).
---

**6. claim: 15(partially)**

The device of claim 1, wherein the target property comprises astigmatism (claim 15, first alternative).
---

Europäisches
Patentamt

European
Patent Office

Office européen
des brevets

**LACK OF UNITY OF INVENTION
SHEET B**

**Application Number**

**EP 21 21 7583**

The Search Division considers that the present European patent application does not comply with the requirements of unity of invention and relates to several inventions or groups of inventions, namely:

     **7. claim: 15(partially)**

        **The device of claim 1, wherein the target property comprises
field curvature (claim 15, second alternative).**
                ---

     **8. claim: 15(partially)**

        **The device of claim 1, wherein the target property comprises
distortion (claim 15, third alternative).**
                ---

     **9. claim: 15(partially)**

        **The device of claim 1, wherein the target property comprises
coma (claim 15, fourth alternative).**
                ---

# EP 4 202 969 A1

## ANNEX TO THE EUROPEAN SEARCH REPORT
## ON EUROPEAN PATENT APPLICATION NO.

EP 21 21 7583

This annex lists the patent family members relating to the patent documents cited in  the above-mentioned European search report.
The members are as contained in the European Patent Office EDP file on
The European Patent Office is in no way liable for these particulars which are merely given for the purpose of information.

27-05-2022

| Patent document cited in search report | | Publication date | Patent family member(s) | | Publication date |
|---|---|---|---|---|---|
| US 2009212229 | A1 | 27-08-2009 | CN | 102017053 A | 13-04-2011 |
| | | | EP | 2260499 A1 | 15-12-2010 |
| | | | JP | 5619629 B2 | 05-11-2014 |
| | | | JP | 2011513905 A | 28-04-2011 |
| | | | KR | 20100132509 A | 17-12-2010 |
| | | | TW | 200952022 A | 16-12-2009 |
| | | | US | 2009212229 A1 | 27-08-2009 |
| | | | US | 2012061583 A1 | 15-03-2012 |
| | | | WO | 2009106560 A1 | 03-09-2009 |
| US 2004232349 | A1 | 25-11-2004 | CN | 1759465 A | 12-04-2006 |
| | | | EP | 1602121 A2 | 07-12-2005 |
| | | | EP | 2503587 A2 | 26-09-2012 |
| | | | JP | 4484868 B2 | 16-06-2010 |
| | | | JP | 2006520078 A | 31-08-2006 |
| | | | KR | 20050102688 A | 26-10-2005 |
| | | | US | 7348567 B1 | 25-03-2008 |
| | | | US | 2004232349 A1 | 25-11-2004 |
| | | | US | 2007018112 A1 | 25-01-2007 |
| | | | US | 2007029499 A1 | 08-02-2007 |
| | | | US | 2007029509 A1 | 08-02-2007 |
| | | | WO | 2004081910 A2 | 23-09-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1602121 A1
- EP 2702595 A1
- EP 2715768 A2
- US 20100276606 A
- EP 20184160
- EP 21166214 A
- EP 21171877 A
- EP 2425444 A
- EP 2021084737 W